# EUROPEAN PATENT APPLICATION

(11) **EP 4 618 727 A1**
(43) Date of publication of application: **17.09.2025**
(21) Application number: 25162068.8
(22) Date of filing: 06.03.2025
(51) Int. Cl.: H10F 19/40

(54) **SOLAR CELL AND PHOTOVOLTAIC POWER GENERATION SYSTEM**

(30) Priority: 13.03.2024 JP 2024039497
(71) Applicant: Kabushiki Kaisha Toshiba, Minato-ku Tokyo 105-0023 (JP)
(72) Inventor: SHIBASAKI, Soichiro, Minato-ku, Tokyo 105-0023 (JP); WAKAMATSU, Kodai, Minato-ku, Tokyo 105-0023 (JP); YAMAMOTO, Kazushige, Minato-ku, Tokyo 105-0023 (JP)
(74) Representative: Hoffmann Eitle

(57) **Abstract**

A solar cell according to an embodiment includes a top cell which is a transparent-type top cell. When the top cell is connected to a bottom cell, the solar cell includes a refractive index-varying layer or a supporting layer including a refractive index-varying region on the side of the bottom cell and a gap layer between the refractive index-varying layer and the bottom cell or between the supporting layer and the bottom cell. The refractive index-varying layer on the side of the top cell has a higher refractive index. The refractive index-varying layer on the side of the bottom cell has a lower refractive index. The refractive index-varying region on the side of the top cell has a higher refractive index. The refractive index-varying region on the side of the bottom cell has a lower refractive index. The gap layer can isolate electronically the top cell from the bottom cell.

## Description

### FIELD

Embodiments described herein relate generally to a solar cell and a photovoltaic power generation system.

### BACKGROUND

High efficiency solar cells are anticipated by combining a top cell (solar cell) with a wide-bandgap light-absorbing layer and a bottom cell (solar cell) with a narrow-bandgap light-absorbing layer.

### BRIEF DESCRIPTION OF THE DRAWINGS

FIG. 1 is a schematic diagram of a solar cell according to an embodiment.
FIG. 2 is a schematic diagram of a solar cell according to an embodiment.
FIG. 3 is a schematic diagram showing the positional relationship between the power generation effective area and the holding part of the top cell.
FIG. 4 is a schematic diagram showing the positional relationship between the power generation effective area and the holding part of the bottom cell.
FIG. 5 is a schematic diagram of a solar cell according to an embodiment.
FIG. 6 is a schematic diagram of a solar cell according to an embodiment.
FIG. 7 is a schematic diagram of a solar cell according to an embodiment.
FIG. 8 is a schematic diagram of a solar cell according to an embodiment.
FIG. 9 is a schematic diagram of a solar cell according to an embodiment.
FIG. 10 is a schematic diagram of a solar cell according to an embodiment.
FIG. 11 is a schematic diagram of a solar cell according to an embodiment.
FIG. 12 is a block diagram of a solar power generation system according to an embodiment.
FIG. 13 is a schematic diagram of a vehicle according to an embodiment.
FIG. 14 is a schematic diagram of an aircraft according to an embodiment.
FIG. 15 is a table related to an example.
FIG. 16 is a table related to an example.
FIG. 17 is a table related to an example.
FIG. 18 is a table related to an example.
FIG. 19 is a table related to an example.
FIG. 20 is a table related to an example.
FIG. 21 is a table related to an example.
FIG. 22 is a table related to an example.
FIG. 23 is a table related to an example.
FIG. 24 is a table related to an example.
FIG. 25 is a table related to an example.
FIG. 26 is a table related to an example.
FIG. 27 is a table related to an example.

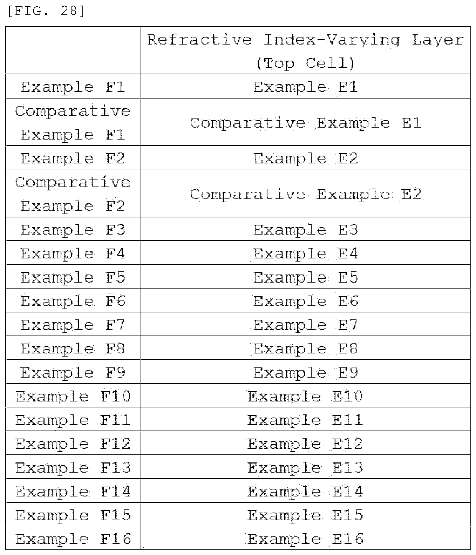

FIG. 28 is a table related to an example.
FIG. 29 is a table related to an example.

### DETAILED DESCRIPTION

A solar cell according to an embodiment includes a top cell which is a transparent-type top cell. When the top cell is connected to a bottom cell, the solar cell includes a supporting layer including a refractive index-varying layer or a refractive index-varying region on the side of the bottom cell and a gap layer between the refractive index-varying layer and the bottom cell or between the supporting layer and the bottom cell. The refractive index-varying layer on the side of the top cell has a higher refractive index. The refractive index-varying layer on the side of the bottom cell has a lower refractive index. The refractive index-varying region on the side of the top cell has a higher refractive index. The refractive index-varying region on the side of the bottom cell has a lower refractive index. The gap layer can isolate electronically the top cell from the bottom cell.

Hereinafter, an embodiment will be described in detail with reference to the drawings. Unless otherwise specified, values at 25°C and 1 atm (atmosphere) are illustrated. An average represents an arithmetic mean value. Each concentration is an average concentration in the region or layer of interest. In each layer, the presence of a specific element is, for example, an element whose presence is confirmed by SIMS (Secondary Ion Mass Spectrometry), and the absence of a specific element is, for example, an element whose presence cannot be confirmed by SIMS.

In the specification, "/" (slash) represents the division sign excluding "/" of "and/or". In the specification, "·" (middle dot, dot operator) represents a multiplication sign. In the specification, "." (period) of a numerical value represents a decimal point.

### (FIRST EMBODIMENT)

A first embodiment relates to a solar cell.

A solar cell of an embodiment includes a transparent-type solar cell, a bottom cell, a refractive index-varying layer or a supporting layer including a refractive index-varying region between the top cell and the bottom cell, and a gap layer between the refractive index-varying layer and the bottom cell or between the supporting layer and the bottom cell. The refractive index-varying layer on the side of the top cell has a higher refractive index. The refractive index-varying layer on the side of the bottom cell has a lower refractive index. The refractive index-varying region on the side of the top cell has a higher refractive index. The refractive index-varying region on the side of the bottom cell has a lower refractive index. The gap layer isolates electronically the top cell from the bottom cell.

A solar cell of an embodiment includes a top cell which is a transparent-type top cell. When the top cell is connected to a bottom cell, the solar cell includes a refractive index-varying layer or a supporting layer including a refractive index-varying region on the side of the bottom cell and a gap layer between the refractive index-varying layer and the bottom cell or between the supporting layer and the bottom cell. The refractive index-varying layer on the side of the top cell has a higher refractive index. The refractive index-varying layer on the side of the bottom cell has a lower refractive index. The refractive index-varying region on the side of the top cell has a higher refractive index. The refractive index-varying region on the side of the bottom cell has a lower refractive index. The gap layer can isolate electronically the top cell from the bottom cell.

A solar cell of an embodiment includes a top cell which is a transparent-type top cell. When the top cell is connected to a bottom cell, the solar cell includes a refractive index-varying layer or a supporting layer including a refractive index-varying region on the side of the bottom cell and a gap layer between the refractive index-varying layer and the bottom cell or between the supporting layer and the bottom cell. The refractive index-varying layer on the side of the top cell has a higher refractive index. The refractive index-varying layer on the side of the bottom cell has a lower refractive index. The refractive index-varying region on the side of the top cell has a higher refractive index. The refractive index-varying region on the side of the bottom cell has a lower refractive index. The refractive index-varying layer is not in direct contact with the bottom cell. The supporting layer is not in direct contact with the bottom cell.

A solar cell of an embodiment includes a top cell which is a transparent-type top cell and a refractive index-varying layer or a supporting layer including a refractive index-varying region on the side of light-exiting surface. The refractive index-varying layer on the side of the top cell has a higher refractive index. The refractive index-varying layer on the opposite side of the top cell has a lower refractive index. The refractive index-varying region on the side of the top cell has a higher refractive index. The refractive index-varying region on the opposite side of top cell has a lower refractive index.

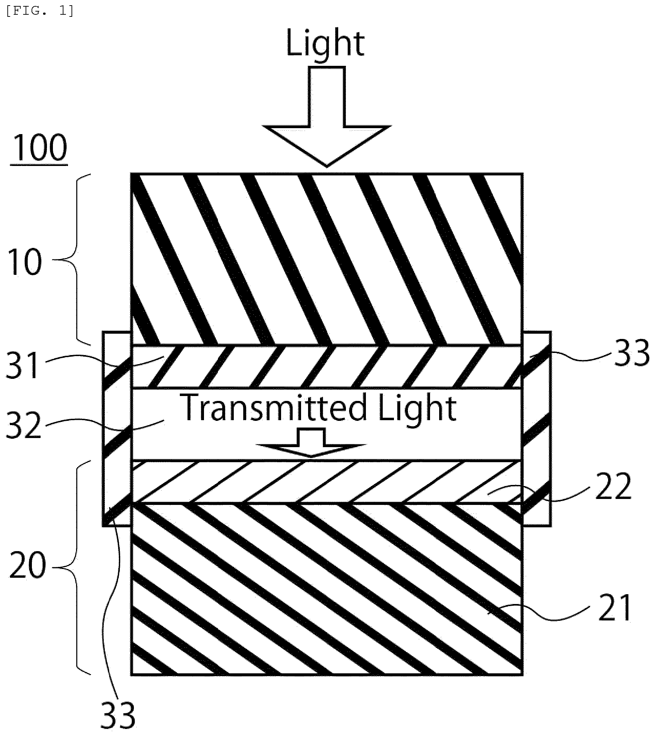

A schematic diagram of a solar cell is shown in FIG. 1. The solar cell 100 of the schematic diagram of FIG. 1 includes the top cell 10, the bottom cell 20, the refractive index-varying layer 31, the gap layer 32, and the holding member 33. The solar cell of the first embodiment shown in the schematic diagram of FIG. 1 may also represent a solar cell module.

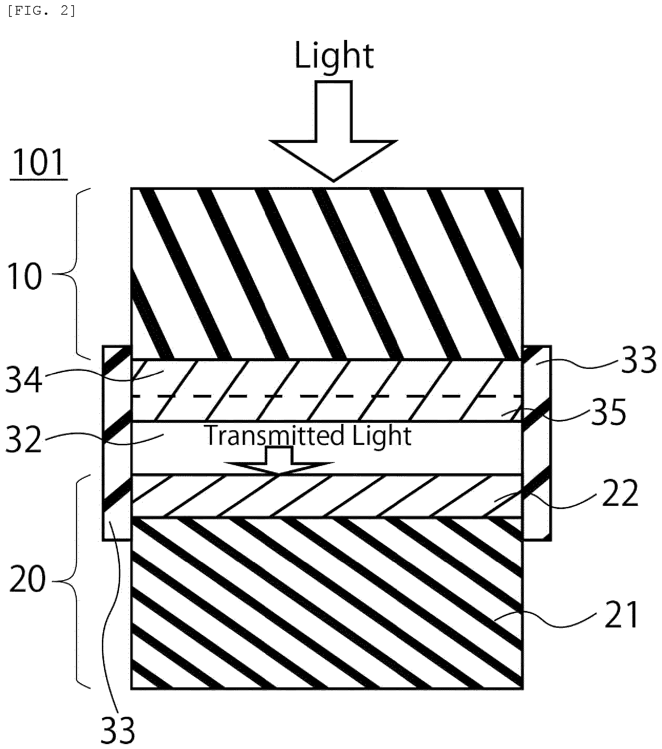

The first embodiment includes the solar cell 101 shown in FIG. 2 as a variation of the solar cell 100
The solar cell 101 shown in FIG. 2 includes the top cell 10, the bottom cell 20, the supporting layer 34 including the refractive index-varying region 35, the gap layer 32, and the holding member 33. The refractive index-varying region 35 corresponds to the refractive index-varying layer 31 of the solar cell 100.

The embodiment of the solar cell in which the top cell 10 is connected to the bottom cell 20 will be described.

Hereinafter, the solar cell 100 will be described mainly. The descriptions of the solar cell 100 may correspond to that of the solar cell 101. The embodiment may include submodules with the top cells 10 connected electronically. The embodiment may include submodules with the bottom cells 20 connected electronically. The solar cell of the embodiment may include the submodules of the top cells and busbars which are provided between the submodules and connect the submodules.

The top cell 10 is a solar cell including a light-absorbing layer whose bandgap is wider than that of the bottom cell 22. The top cell 10 is a transparent-type solar cell. The top cell 10 absorbs a portion of incident light to generate electric power and transmits another portion of the incident light.

One or more of selected from the group consisting of a compound semiconductor, a perovskite compound, and amorphous silicon may be used as the light-absorbing layer of the top cell 10. The compound semiconductor, the perovskite compound, or the amorphous silicon is preferable for the light-absorbing layer of the top cell 10. A cuprous oxide (cuprous oxide compound having a cuprite structure), a compound having a chalcopyrite structure (CIS, CIGS), a compound having a kesterite structure, a compound having a stannite structure, and a chalcogenide of transition metal are preferable as the compound semiconductor.
transition metal chalcogenides.

One or more of additional solar cells not shown in drawings may be provided on the light incident side of the solar cell 100. An embodiment where light transmitted through the additional cell enters the incident surface of the top cell is also included.

Light enters the top cell 10 from the opposite side of the bottom cell 20. The top cell 10 has a light-incident surface on the opposite side of bottom cell 20.

Light entering the top cell 10 from the light-incident surface on the opposite side of the bottom cell 20 exits from the side of the bottom cell 20.

The bottom cell 20 is a solar cell that has a light-absorbing layer with a narrower band gap than that of the top cell 10. Light transmitted through the top cell 10 (transmitted light) enters the bottom cell 20, and the bottom cell 20 generates electric power. The bottom cell 20 is a non-transparent-type solar cell.

The bottom cell 20 includes a power generation element 21 and an anti-reflection layer 22 on the side of the top cell 10. From the viewpoint of reducing reflection at the interface between the gap layer 32 and the anti-reflection layer 22, it is preferable that the refractive index of the surface of the anti-reflection layer 22 on the side of top cell 10 is substantially 1.0 or more and 1.35 or less, 1.0 or more and 1.30 or less, 1.0 or more and 1.1 or less, and more preferably 1.0 or more 1.08 or less. Alternatively, a structure with continuously graded refractive index may be included by forming unevenness on the surface of the bottom cell 20 on the side of the top cell 10. The refractive index referred to in this specification is the refractive index for light with a wavelength in the range of 600 [nm] or more to 900 [nm] or less. The refractive index can be determined, for example, by using a spectroscopic ellipsometer.

As the light-absorbing layer of the bottom cell 20, polycrystalline or monocrystalline Si is preferable.

Light enters the bottom cell 20 from the side of the top cell 10. The bottom cell 20 has a light incident surface on the side of the top cell 10.

In addition to the anti-reflective film 22, an electrode of the bottom cell 20 may be provided on the light incident surface side of the bottom cell 20.

The refractive index-varying layer 31 (the supporting layer 34 including the refractive index-varying region 35) is placed on the bottom cell on the side of the top cell 10. The refractive index-varying layer 31 (the supporting layer 34 including the refractive index-varying region 35) is placed between the top cell 10 and the bottom cell 20. The refractive index-varying layer 31 (the supporting layer 34 including the refractive index-varying region 35) is preferably placed on the light-exiting surface of the top cell 10. The refractive index-varying layer 31 (the supporting layer 34 including the refractive index-varying region 35) is transparent. It is preferable that the refractive index-varying layer 31 (the supporting layer 34 including the refractive index-varying region 35) is in direct contact with the top cell 10. The light which passes through the top cell 10 exits from the refractive index-varying layer 31 (the supporting layer 34 including the refractive index-varying region 35) and reaches at the bottom cell 20 via the gap layer 32. The refractive index-varying layer 31 (the refractive index-varying region 35) has a refractive index distribution. It is preferable that refractive index of a region of the supporting layer 34 excluding the refractive index-varying region 35 is constant or approximately constant.

The refractive index-varying layer 31 (the supporting layer 34 including the refractive index-varying region 35) is not in direct contact with the bottom cell 20.

The refractive index-varying region 35 is not in direct contact with the bottom cell 20.

A region whose refractive index is lower than the other region in the refractive index-varying layer 31 and is approximately constant, may be included in the refractive index-varying layer 31 on the side of the bottom cell 20.

A region whose refractive index is lower than the other region in the refractive index-varying region 35 and is approximately constant, may be included in the refractive index-varying region 35 on the side of the bottom cell 20.

The refractive index-varying region 35 of the supporting layer 34 is a region where the refractive index is varied (graded) since the composition is different between the side of the top cell 10 and the other region or/and the shape is different between the side of the top cell 10 and the other region.

The refractive index-varying layer 31 (the refractive index-varying region 35) on the side of the top cell 10 has a higher refractive index. The refractive index-varying layer 31 (the refractive index-varying region 35) on the side of the bottom cell 20 has a lower refractive index. The refractive index of the refractive index-varying layer 31 (the refractive index-varying region 35) on the side of the top cell 10 is higher than that of the refractive index-varying layer 31 (the refractive index-varying region 35) on the side of the bottom cell 20.

A thickness of the refractive index-varying layer 31 (length of the refractive index-varying layer 31 in a stacking direction the top cell 10 and the bottom cell 20) is preferably 0.01 [µm] or more and 2[mm] or less and more preferably 0.02 [µm] or more and 1.5 [mm] or less, even more preferably 0.03 [µm] or more and 1 [mm] or less.

A thickness of the refractive index-varying region 35 (length of the refractive index-varying region 35 in the stacking direction the top cell 10 and the bottom cell 20) is preferably 0.01 [µm] or more and 2[mm] or less and more preferably 0.02 [µm] or more and 1.5 [mm] or less, even more preferably 0.03 [µm] or more and 1 [mm] or less.

A thickness of the supporting layer 34 (length of the supporting layer 34 in the stacking direction the top cell 10 and the bottom cell 20) is preferably 0.01 [µm] or more and 2[mm] or less and more preferably 0.02 [µm] or more and 1.5 [mm] or less, even more preferably 0.03 [µm] or more and 1 [mm] or less.

It is preferable that the refractive index-varying layer 31 (the supporting layer 34 including the refractive index-varying region 35) is electrically insulative. The refractive index-varying layer 31 (the supporting layer 34 including the refractive index-varying region 35) may include inorganic materials such as glass and/or resin materials. Inorganic materials such as super white glass, chemically strengthened glass, borosilicate glass, and quartz can be used as a glass of the refractive index-varying layer 31 (the supporting layer 34 including the refractive index-varying region 35). Resin materials for he refractive index-varying layer 31 (the supporting layer 34 including the refractive index-varying region 35) include acrylic resins, epoxy resins, silicone resins, polyimides, polycarbonate, polyethylene terephthalate (PET), polypropylene (PP), fluorine-based resins (polytetrafluoroethylene (PTFE), perfluoroethylene propylene copolymer (FEP), ethylene tetrafluoroethylene copolymer (ETFE), polychlorotrifluoroethylene (PCTFE), perfluoroalkoxyalkane (PFA)), polyarylate, polysulfone, polyethersulfone and polyetherimide.

The top cell 10 and the bottom cell 20 are not connected electrically by the refractive index-varying layer 31 (the supporting layer 34 including the refractive index-varying region 35). The top cell 10 and the bottom cell 20 are isolated electrically by the refractive index-varying layer 31 (the supporting layer 34 including the refractive index-varying region 35). Electrical resistance of the refractive index-varying layer 31 (the supporting layer 34 including the refractive index-varying region 35) is preferably 10⁹ [Ω] (10E9[ohm]) or more and more preferably 10¹² [Ω] (10E12 [ohm]) or more.

It is preferable that the top cell 10 has output terminals independent from output terminals of the bottom cell 20. It is preferable that the bottom cell 20 has output terminals independent from output terminals of the top cell 10. The voltage and/or the current of the top cell 10 (one or more submodules each including the top cells 10) and the bottom cell 20 (one or more submodules each including the bottom cells 20) does not need to match since the top cell 10 and the bottom cell 20 are connected in the stacking direction of the top cell 10 and the bottom cell 20.

The refractive index-varying layer 31 (the supporting layer 34 including the refractive index-varying region 35) includes any of a stack of members with different refractive indices, a member whose refractive index varies gradually, and a member whose refractive index varies due to unevenness (concave and convex structure). The unevenness-shape of the refractive index-varying layer 31 (the supporting layer 34 including the refractive index-varying region 35) is not particularly limited. The unevenness-shape may be in the form of a cone (needle-like), truncated cone, pyramid, or truncated pyramid each tapering toward the side of the bottom cell 20 or in the form of grooves tapering toward the side of the bottom cell 20. The pattern of the grooves may include line pattern, mesh pattern, random pattern or the like. The refractive index-varying layer 31 (the supporting layer 34 including the refractive index-varying region 35) may include inorganic material such as one or more of selected from the group consisting of MgF₂, SiNₓ, TiO₂, Al₂O₃, and SiO₂, or carbon nanoparticles.

The refractive index of the surface of the refractive index-varying layer 31(the refractive index-varying region 35) on the side of the bottom cell 20 (the gap layer 32 side or opposite side of the top cell 10) is preferably 1.0 or more and 1.35 or less, preferably 1.0 or more and 1.30 or less, preferably 1.0 or more and 1.1 or less, and more preferably 1.0 or more and 1.08 or less. It is preferable that the light within the wavelength band used for power generation in bottom cell 20 does not reflect when exiting from top cell 10.

It is preferred that the refractive index of the refractive index-varying layer 31 (the refractive index-varying region 35) on the side of the top cell 10 is higher than the refractive index of the refractive index of the refractive index-varying layer 31(the refractive index-varying region 35) on the side of the bottom cell 20. The refractive index of the refractive index-varying layer 31 on the side of the top cell 10 is refractive index of a region from a position at 10% depth of the refractive index-varying layer 31 from the surface of the refractive index-varying layer 31 which is in direct contact with the top cell 10 toward the bottom cell 20 to a position at 20% depth of the refractive index-varying layer 31 from the surface toward the bottom cell 20. The refractive index of the refractive index-varying region 35 on the side of the top cell 10 is refractive index of a region from a position at 10% depth of the supporting layer 34 including the refractive index-varying region 35 from the surface of the supporting layer 31 which is in direct contact with the top cell 10 toward the bottom cell 20 to a position at 20% depth of the supporting layer 34 from the surface toward the bottom cell 20. The refractive index of the refractive index-varying layer 34 on the side of the bottom cell 20 is refractive index of a region from a position at 80% depth of the refractive index-varying layer 31 from the surface of the refractive index-varying layer 31 which is in direct contact with the top cell 10 toward the bottom cell 20 to a position at 90% depth of the refractive index-varying layer 31 from the surface toward the bottom cell 20. The refractive index of the refractive index-varying region 35 on the side of the bottom cell 20 is refractive index of a region from a position at 80% depth of the supporting layer 34 including the refractive index-varying region 35 from the surface of the supporting layer 34 which is in direct contact with the top cell 10 toward the bottom cell 20 to a position at 90% depth of the supporting layer 34 from the surface toward the bottom cell 20. An absolute value of difference between refractive index of a member of the top cell 10 which is in direct contact with the refractive index-varying layer 31 and the refractive index of the refractive index-varying layer 31 on the side of the top cell 10 (|[refractive index of a member of the top cell 10 which is in direct contact with the refractive index-varying layer 31] - [refractive index of the refractive index-varying layer 31 on the side of the top cell 10]|) is preferably 0.0 or more and 1.0 or less and more preferably 0.0 or more and 0.5 or less. An absolute value of difference between refractive index of a member of the top cell 10 which is in direct contact with the supporting layer 34 and refractive index of a region excluding the refractive index-varying region 35 on the side of the top cell 10 (|[refractive index of a member of the top cell 10 which is in direct contact with the supporting layer 34] - [refractive index of a region excluding the refractive index-varying region 35 on the side of the top cell 10]|) is 0.0 or more and 1.0 or less and more preferably 0.0 or more and 0.5 or less.

The difference between the refractive index of a member of the top cell 10 which is in direct contact with the refractive index-varying layer 31 and the refractive index of the refractive index-varying layer 31 on the side of the top cell 10 ([refractive index of a member of the top cell 10 which is in direct contact with the refractive index-varying layer 31] - [refractive index of the refractive index-varying layer 31 on the side of the top cell 10]) is preferably -1.0 or more and 1.0 or less and more preferably -0.5 or more and 0.5 or less. The difference between refractive index of a member of the top cell 10 which is in direct contact with the supporting layer 34 and the refractive index of the region excluding the refractive index-varying region 35 on the side of the top cell 10 ([refractive index of a member of the top cell 10 which is in direct contact with the supporting layer 34] - [refractive index of the region excluding the refractive index-varying region 35 on the side of the top cell 10]) is -1.0 or more and 1.0 or less and more preferably -0.5 or more and 0.5 or less.

The refractive index of the top cell 10 on the refractive index-varying layer 31 side (the refractive index of the member of the top cell 10 which is in direct contact with the refractive index-varying layer 31) is preferably 1.3 or more and 2.2 or less and more preferably 1.4 or more and 2.0 or less.

The refractive index of the top cell 10 on the supporting layer 34 side (the refractive index of the member of the top cell 10 which is in direct contact with the supporting layer 34) is preferably 1.3 or more and 2.2 or less and more preferably 1.4 or more and 2.0 or less.

The refractive index-varying layer 31 (the refractive index-varying region 35) on the side of the bottom cell 20 preferably have a surface having unevenness. The height of the unevenness is preferably 20 [nm] or more and less than 1000 [nm] and preferably 60 [nm] or more and 800 [nm] or less. The spacing of the unevenness is 20 [nm] or more and less than 1000 [nm] and preferably 60 [nm] or more and 800 [nm] or less. The unevenness may have regular pattern or irregular pattern. It is preferable that the surface having unevenness of the refractive index-varying layer 31 (the refractive index-varying region 35) is in direct contact with the gap layer 32. The convex part of the unevenness of the refractive index-varying layer 31(the refractive index-varying region 35) is provided at the side of the bottom cell 20. The concave part of the unevenness of the refractive index-varying layer 31(the refractive index-varying region 35) is provided on the side of the top cell 10.

It is preferable that the refractive index of the refractive index-varying layer 31 (the refractive index-varying region 35) decreases gradually or/and step-likely towards the side of the bottom cell 20 (the opposite side of the top cell 10) from the side of the top cell 10. When the refractive index of the refractive index-varying layer 31 (the refractive index-varying region 35) is decreased gradually or/and step-likely, the refractive index-varying layer 31 (the refractive index-varying region 35) may include a portion where the refractive index increases towards the side of the bottom cell 20 from the side of the top cell 10.

The gap layer 32 is space existing between the refractive index-varying layer 31 (the supporting layer 34 including the refractive index-varying region 35) and the bottom cell 20. It is preferable that the gap layer 32 is electrically insulative. The gap layer 32 is a layer including (consisting of) air (for example, including atmospheric gas of 1 [Pa] or more and 10⁶ [Pa] or less), a layer including (consisting of) inert gas or a layer of vacuumed region (0 [Pa] or more and less than 10⁶ [Pa]).

In the configuration where the top cell 10 and the bottom cell 20 are connected, the gap layer 32 electrically isolates the top cell 10 from the bottom cell 20.

When the embodiment configuration comprises the top cell 10, which is connected to the bottom cell 20 not included in the embodiment configuration, the gap layer 32 can electrically isolate the top cell 10 from the bottom cell 20.

The thickness of the gap layer 32 (length of the gap layer 32 in the stacking direction of the top cell 10 and the bottom cell 20) is preferably 1 [µm] or more and 10 [mm] or less, more preferably 5 [µm] or more and 5 [mm] or less, and still more preferably 10 [µm] or more and 3 [mm] or less.

The minimum thickness of the gap layer 32 (minimum length of the gap layer 32 in the stacking direction of the top cell 10 and the bottom cell 20) is preferably 0.1 [µm] or more and 10 [mm] or less, more preferably 1 [µm] or more and 5 [mm] or less, and still more preferably 5 [µm] or more and 3 [mm] or less. When the refractive index-varying layer 31(the supporting layer 34 including the refractive index-varying region 35) is in direct contact with the bottom cell 20, the minimum thickness of the gap layer 32 is 0 [µm] or more and the thickness of the gap layer 32 (length of the gap layer 32 in the stacking direction of the top cell 10 and the bottom cell 20) is preferably 0.01 [µm] or more and 2 [mm]or less, more preferably 0.02 [µm] or more and 1.5 [mm] or less, and still more preferably 0.03 [µm] or more and 1 [mm] or less.

The refractive index of the gap layer 32 is about 1. The overall refractive index layer of the gap layer 32 is about 1. The overall refractive index of the gap layer 32 is preferably 1.0 or more and 1.2 or less. In order to decrease reflection at the interfaces between the refractive index-varying layer 31 (the supporting layer 34) and the gap layer 32 and between the anti-reflection layer 22 and the gap layer 32, the solar cell 100 of the embodiment includes the refractive index-varying layer 31 (the supporting layer 34 including the refractive index-varying region 35), the gap layer 32 and the anti-reflection layer 22.

It is preferable that the solar cell 100 is not connected to the bottom cell 20 with an adhesive layer which covers the power generation element 21 and the refractive index-varying layer 31(the supporting layer 34) is not also connected to the bottom cell 20 by the adhesive layer. Therefore, it is preferable that no adhesive layer exists between the refractive index-varying layer 31 (the supporting layer 34) and the power generation element 21 of the bottom cell 20 in the stacking direction of the top cell 10 and the bottom cell 20. It is preferable that any layers other than the gap layer 32 exists between the refractive index-varying layer 31 (the supporting layer 34) and the bottom cell 20 in the stacking direction of the top cell 10 and the bottom cell 20. A member such as the holding member 33 and an adhesive layer not shown in drawings may be provided between members excluding between the refractive index-varying layer 31 (the supporting layer 34) and the power generation element 21 of the bottom cell 20.

The anti-reflection layer 22 and the refractive index-varying layer 31 (the supporting layer 34) of the solar cell 100 of the embodiment is configured to prevent reflection at the interface with the gap layer 32. If the top cell 10 is connected to the bottom cell 20 using an adhesive layer or the like without the gap layer 20, a member of the top cell 10 on the side of the bottom cell 20 (for example, a substrate or a transparent electrode) is in direct contact with the adhesive layer. Since refractive index of the adhesive layer is, for example, 1.5, difference in the refractive index between the adhesive layer and the bottom cell 20 may be larger than difference in the refractive index between the gap layer 32 and the bottom layer 20, and the reflection at the interface between the bottom cell 20 and the adhesive layer will be increased. Since the transmitted light which passed through the top cell 10, passes through the refractive index-varying layer 31 (the supporting layer 34) and the gap layer 32, the transmitted light which passed through the side of the top cell 10 and is minimally reflected, can be reached to the light incident surface of the bottom cell 20. By placing the anti-reflection layer 22 on the light incident side of the bottom cell 20, the reflection at the interface between the gap layer 32 which is a medium whose refractive index is usually 1 and the anti-reflection layer 22 is effectively reduced. Since a configuration that the region between the top cell 10 and the bottom cell 20 is encapsuled with adhesive agent is intentionally avoided and the light passed through the top cell 10 is introduced to the side of the bottom cell 20 via the air layer, the reflection at interfaces from the top cell 10 to the light incident side of the bottom cell 20 is effectively reduced.

When the configuration that the region between the top cell 10 and the bottom cell 20 is encapsulated with the adhesive agent is adopted and the anti-reflection layer 22 whose refractive index on the side of the top cell 10 is close to 1 (for example, 1.1) is provided on the light incident side of the bottom cell 20, the reflection may be increased which is caused by difference in the refractive index of the adhesive agent and the anti-reflection layer 22. The top cell 10 of the embodiment can increases the amount of the generated power since the top cell 10 (the solar cell 100) is configured to reduce the reflection at the interface between the medium (air gap layer) with a refractive index of approximately 1 and the light-exiting surface of the top cell 10 and the interface between the light incident surface of the bottom cell 20 and the medium.

The gap layer 32 is an insulating region. The bottom cell 20 is not connected electrically to the bottom cell 20 via the refractive index-varying layer 31 (the supporting layer 34) and the gap layer 32. The bottom cell 20 is isolated electrically from the bottom cell 20 via the refractive index-varying layer 31 (the supporting layer 34) and the gap layer 32. When the refractive index-varying layer 31 (the supporting layer 34) is physically separated from the bottom cell 20, unevenness or grooves on the surface of the refractive index-varying layer 31 (the supporting layer 34) may be formed by providing glassy carbon on the surface.

When a sheet insulating film or an organic-compound layer whose refractive index is higher than that of the refractive index-varying layer 31 (the supporting layer 34 including the refractive index-varying region 35) on the side of the bottom cell 20 (on the opposite side of the top cell 10) is provided between the refractive index-varying layer 31 (the supporting layer 34 including the refractive index-varying region 35) and the gap layer 32, reflection at the interface between the refractive index-varying layer 31 (the supporting layer 34 including the refractive index-varying region 35) and the sheet insulating film or the organic-compound layer and the interface between the bottom cell 20 and the sheet insulating film or the organic-compound layer will be increased, resulting in decreased intensity of the light reaching the bottom cell 20. When the top cell 10 is connected to the bottom cell 20 using the member with a low refractive index and the gap layer 32, both the reflection at the light-exiting surface of the top cell 20 and the reflection at the light incident surface of the bottom cell 20 can be reduced.

The holding member 33 secures the top cell 10 or/and the refractive index-varying layer 31 (the supporting layer 34 with the bottom cell 20. The holding member 33 holds the bottom cell 20 and the top cell 10 or/and the refractive index-varying layer 31 (the supporting layer 34), resulting in the formation of the gap layer 32. A protrusion of the refractive index-varying layer 31 (the supporting layer 34) can work as the holding member 33.

It is preferable that the holding member 33 is provided outside of a power generation effective region of the top cell 10 and the bottom cell 20. The outside of the power generation effective region is a region which does not overlap with the light-absorbing layer of the bottom cell 20 in the stacking direction of the top cell 10 and the bottom cell 20.

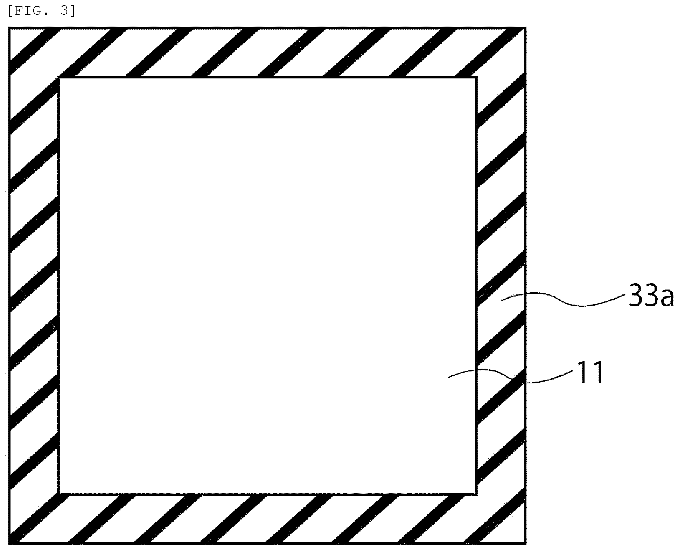

A schematic diagram of FIG. 3 illustrates a positional relationship between the power generation effective region 11 of the top cell 10 and the holding member 33. It is preferable that the holding member 33 is placed in the region 33a with the hatching illustrated in FIG. 3. The power generation effective region 11 of the top cell 10 is a region, for example, where the light-absorbing layer of the top cell 10. Preferably 95 % or more and 100 % or less of an area of the power generation effective region 11 in the stacking direction of the top cell 10 and the bottom cell 20, more preferably 98 % or more and 100 % or less of an area of the power generation effective region 11 in the stacking direction, and still more preferably 99 % or more and 100 % or less of the area of the power generation effective region 11 in the stacking direction is not overlapped with the holding member 33. Preferably 100 % of the area of the power generation effective region 11 in the stacking direction is not overlapped with the holding member 33.

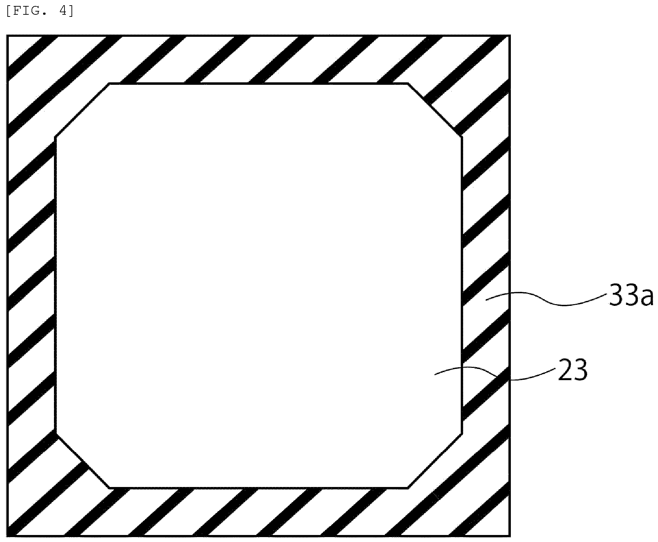

A schematic diagram of FIG. 4 illustrates the positional relationship between the power generation effective region 23 of the bottom cell 20 and the holding member 33. It is preferable that the holding member 33 is placed in the region 33a with the hatching illustrated in FIG. 4. The power generation effective region 23 of the top cell 10 is a region, for example, where the light-absorbing layer of the top cell 10 is located. Preferably 95 % or more and 100 or less of an area of the power generation effective region 23 in the stacking direction of the top cell 10 and the bottom cell 20, more preferably 98 % or more and 100 % or less of an area of the power generation effective region 23 in the stacking direction, and still more preferably 99 % or more and 100 % or less of the area of the power generation effective region 23 in the stacking direction is not overlapped with the holding member 33. Preferably 100 % of the area of the power generation effective region 11 in the stacking direction is not overlapped with the holding member 33.

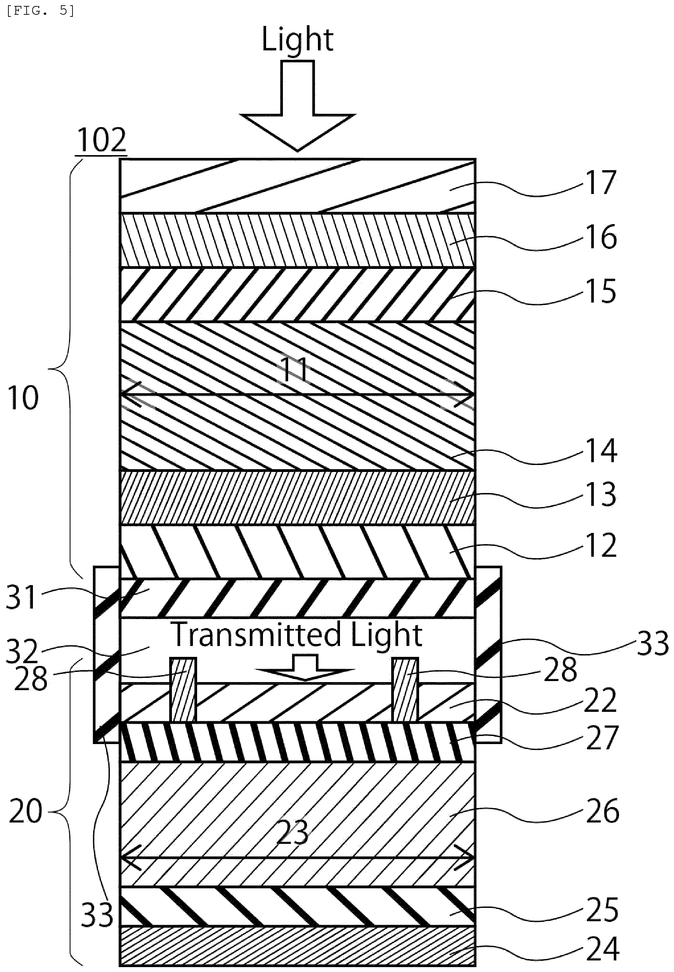

A schematic diagram of FIG. 5 illustrates the solar cell 102 as specified example of the solar cell 100. The solar cell 102 shown in the schematic diagram of FIG. 5 includes, from the light incident side, the anti-reflection layer 17, the first n-electrode 16, the n-type layer 15, the p-type light-absorbing layer 14, the first p-electrode 13, the substrate 12, the refractive index-varying layer 31, the gap layer 32, the second p-electrode 28, the anti-reflection layer 22, the p-type layer 27, the n-type light-absorbing layer 26, the BSF layer 25, and the second n-type layer 24. The top cell including the compound semiconductor layer as the p-type light-absorbing layer 14 is illustrated in the top cell 10. Depending on material used for the p-type light-absorbing layer 14, appropriate configuration of the top cell 10 is preferably adopted.

The substrate 12 is a transparent substrate. A transparent organic substrates such as acrylic, polyimide, polycarbonate, polyethylene terephthalate (PET), polypropylene (PP), fluorine-based resins (polytetrafluoroethylene (PTFE), perfluoroethylene, propene copolymer (FEP), ethylene tetrafluoroethylene copolymer (ETFE), polychlorotrifluoroethylene (PCTFE), perfluoroalkoxy alkane (PFA), and the like), polyarylate, polysulfone, polyethersulfone, and polyetherimide and inorganic substrates such as soda lime glass, white glass, chemically strengthened glass, and quartz can be used as the substrate 12. As the substrate 12, the substrates listed above can be laminated.

The first p-electrode 13 is provided on the substrate 12 and is disposed between the substrate 12 and the p-type light-absorbing layer 14. The first p-electrode 13 preferably forms ohmic contact with the p-type light-absorbing layer 14. The p-electrode 13 is provided on the p-type light-absorbing layer 14 side and is a conductive layer that exhibits optical transmittance in wavelengths from approximately 1200 nm to visible light. A thickness of the first p-electrode 13 is typically 50 [nm] or more and 2000 [nm] or less. In FIG. 5, the first p-electrode 13 is in direct contact with the p-type light-absorbing layer 14. It is preferable that the first p-electrode 13 includes one or more layers of transparent conductive oxide films. The transparent conductive oxide film is not particularly limited, and is an indium tin oxide (ITO), an Al-doped zinc oxide (AZO), a boron-doped zinc oxide (BZO), a gallium-doped zinc Oxide (GZO), a doped tin oxide, a titanium-doped indium oxide (ITiO), an indium zinc oxide (IZO), an indium gallium zinc oxide (IGZO), a hydrogen-doped indium oxide (IOH), or the like. The transparent conductive oxide film may be a stacked film having a plurality of films. A dopant for a film of tin oxide or the like is not particularly limited as long as the dopant is one or more elements selected from the group consisting of In, Si, Ge, Ti, Cu, Sb, Nb, Ta, W, Mo, F, Cl, and the like. It is preferable that the first p-electrode 13 is the doped tin oxide which is doped with one or more elements selected from the group consisting of In, Si, Ge, Ti, Cu, Sb, Nb, Ta, W, Mo, F, Cl, and the like. The doped tin oxide film should preferably contain 10 [atom%] or less of the elements selected from the group consisting of In, Si, Ge, Ti, Cu, Sb, Nb, Ta, W, Mo, F and Cl compared to the tin contained in the tin oxide film. As the first p-electrode 13, a stacked film of the transparent conductive film and a metal film is preferably used. A thickness of the metal film is preferably 1 [nm] or more and 500 [µm] or less. Metal (including alloy) included in the metal film is not limited to Mo, Au, Cu, Ag, Al, Ta, W or the like. It is preferable that the first p-electrode 13 includes a dot-shaped, line-shaped, or mesh-shaped electrode (one or more selected from the group consisting of metal, an alloy, graphene, a conductive nitride, and a conductive oxide) between the transparent conductive oxide film and the substrate 12 or between the transparent conductive oxide film and the p-type light-absorbing layer 14. It is preferable that the dot-shaped, line-shaped, or mesh-shaped metal has an aperture ratio of 50% or more with respect to an area of the transparent conductive oxide film. The dot-like, line-like, or mesh-like metal is not particularly limited to, and is Mo, Au, Cu, Ag, Al, Ta, W, or the like. When the metal film is used for the first p-electrode 2, it is preferable that a film thickness is about 5 [nm] or less from the viewpoint of transparency. The metal film is not a solid film but a conductive layer with opening. When the line-shaped or mesh-shaped metal film is used, since the transparency is secured at an opening, the film thickness of the metal film is not limited to the above range. When the top cell 10 is formed, for example, using the refractive index-varying layer 31 as the substrate 12, the solar cell 104 may be formed without additionally using the refractive index-varying layer 31.

It is preferable for a doped tin oxide film that forms an ohmic contact with the p-type light absorbing layer 14 to be provided on the outermost surface of the oxide transparent conductive film side facing the p-type light absorbing layer 14. It is more preferable that at least a portion of the doped tin oxide film provided on the outermost surface of the oxide transparent conductive film side facing the p-type light absorbing layer 14 directly contacts the p-type light absorbing layer 14.

The p-type light-absorbing layer 14 is a light-absorbing layer provided between the n-type layer 15 and the first p-electrode 13. The p-type light-absorbing layer 14 preferably includes one selected from the group consisting of cuprous oxide (cuprous oxide compound having a cuprite structure), a compound having a chalcopyrite structure (CIS, CIGS), a compound having a kesterite structure, a compound having a stannite structure, and a chalcogenide of transition metal. Depending on the type of compound semiconductor, an n-type semiconductor layer can be used in place of the p-type light-absorbing layer 14, and a p-type semiconductor layer can be used in place of the n-type layer 15. An i-type semiconductor layer can be provided between the p-type light-absorbing layer 14 and the n-type layer 15.

The area of the p-type light-absorbing layer 14 is the power generation effective region 11 of the top cell 10.

The n-type layer 15 is a semiconductor layer which forms a p-n junction or a p-i-n junction with the p-type light-absorbing layer 14. Depending on the p-type light-absorbing layer 14, an appropriate layer can be used as the n-type layer 15. As the n-type layer 15, for example, a metal oxide, a metal sulfide or a metal oxysulfide can be used.

The first n-electrode 16 is an electrode on the n-type layer 15 side, which has light transmittance for wavelengths of approximately 1200 [nm] to the ultraviolet region. It is preferable that the first n-electrode 16 is provided on the n-type layer 15. The first n-electrode 16 and the p-type light-absorbing layer 14 sandwich the n-type layer 15. An intermediate layer (not shown) can be provided between the n-type layer 15 and the first n-electrode 16. It is preferable to use a transparent conductive oxide film for the first n-electrode 16. Examples of the transparent conductive oxide film used in the first n-electrode 16 include one or more semiconductor conductive films selected from the group consisting of indium tin oxide, aluminum-doped zinc oxide, boron-doped zinc oxide, gallium-doped zinc oxide, indium-doped zinc oxide, titanium-doped indium oxide, indium gallium zinc oxide, and hydrogen-doped indium oxide. Dopants for films such as tin oxide are not particularly limited, and may be one or more selected from the group consisting of In, Si, Ge, Ti, Cu, Sb, Nb, Ta, W, Mo, F, and Cl. To reduce the resistance of the transparent conductive oxide film in the first n-electrode 16, it may include mesh-shaped or line-shaped electrodes. The materials for the mesh-shaped or line-shaped electrodes are not particularly limited, and examples include Mo, Au, Cu, Ag, Al, Ta, and W. Graphene can also be used for the first n-electrode 16. It is preferable to laminate graphene with silver nanowires.

The thickness of the first n-electrode 16 can be determined by cross-sectional observation using an electron microscope or a step profiler. While not particularly limited, the thickness is typically in the range of 30 [nm] or more and 2 [µm] or less.

It is preferable that the first n-electrode 16 is formed by, for example, atomic layer deposition (ALD) or sputtering.

When a perovskite compound is used as the light-absorbing layer of the top cell 10, instead of the p-type light-absorbing layer 14 and the n-type layer 15, a hole transport layer (e.g., p-type PEDOT:PSS), a light-active layer (e.g., a perovskite compound and a pyrrolidone derivative), and an electron transport layer (e.g., n-type TiO₂) can be used.

An anti-reflection layer 17 is a reflection prevention layer provided on the light incident surface side of the top cell 10. The anti-reflection layer 17 is a layer for suppressing reflection at the light incident surface of the top cell 10. The anti-reflection layer 17 includes inorganic material(s) or organic material(s). The refractive index of the surface on the opposite p-type light absorbing layer 14 side in the anti-reflection layer 17 is preferably 1.0 or more and 1.9 or less. The anti-reflection layer 17 can be a multilayer structure depending on the refractive index of the first n-electrode 16. For example, a structure in which an Al₂O₃ layer provided on the first n-electrode 16 side and a film having a moth-eye-like surface structure are laminated can be adopted, or sputtering films of inorganic materials such as MgF₂, SiNₓ, TiO₂, Al₂O₃, and SiO₂ can be adopted as the anti-reflection layer 17. The light incident surface side of the anti-reflection layer 17 preferably has unevenness (concave and convex structure). The unevenness of the anti-reflection layer 17 is such that the light incident surface side is a convex portion, and the side of the bottom cell 20 is a concave portion. The unevenness includes tapered needle-like unevenness or grooves directed toward the side of the bottom cell 20. The pattern of the groove can be line-shaped, mesh-shaped, random-shaped, etc.

An anti-reflection film 22 is an anti-reflection film provided on the light incident surface side of the bottom cell 20. The anti-reflection film 22 is a layer for suppressing reflection at the light incident surface of the bottom cell 20. The anti-reflection film 22 includes inorganic material(s) or organic material(s). For example, a film having a moth-eye-like surface structure or sputtering films of inorganic materials such as MgF₂, SiNₓ, TiO₂, Al₂O₃, and SiO₂ can be adopted as the anti-reflection film 22. The incident surface side of the anti-reflection film 22 preferably has unevenness. The unevenness of the anti-reflection film 22 is such that the side of the top cell 10 is a convex portion, and power generation element 21 side is a concave portion. The unevenness is tapered needle-like unevenness or grooves directed toward the side of the bottom cell 20. The pattern of the groove can be line-shaped, mesh-shaped, random-shaped, etc.

A PERC (Passivated Emitter and Rear Cell) type Si solar cell is exemplified as the bottom cell 20. However, the bottom cell 20 may be a back contact type, TOPCon (Tunnel Oxide Passivated Contacts) type, or SHJ (Silicon Heterojunction) type Si solar cell. In addition to Si solar cells, a solar cell using a light-absorbing layer having a narrower band gap than the light-absorbing layer of the top cell 10 can be used as the bottom cell 20. Furthermore, a transparent solar cell can be applied to the bottom cell 20.

The second n-electrode 24 is, for example, a solid metal film. As the metal film, an opaque electrode such as Al can be used.

The n-type light absorbing layer 26 is an n-type Si layer.

The area of the n-type light absorbing layer 26 is the power generation effective region 23 of the bottom cell 20.

The BSF (Back Surface Field) layer 25 is, for example, an AlO/SiN layer.

The p-type layer 27 is a p-type Si layer.

The second p-electrode 28 is, for example, an Ag collection electrode. The second p-electrode 28 is an electrode that penetrates the anti-reflection film 22.

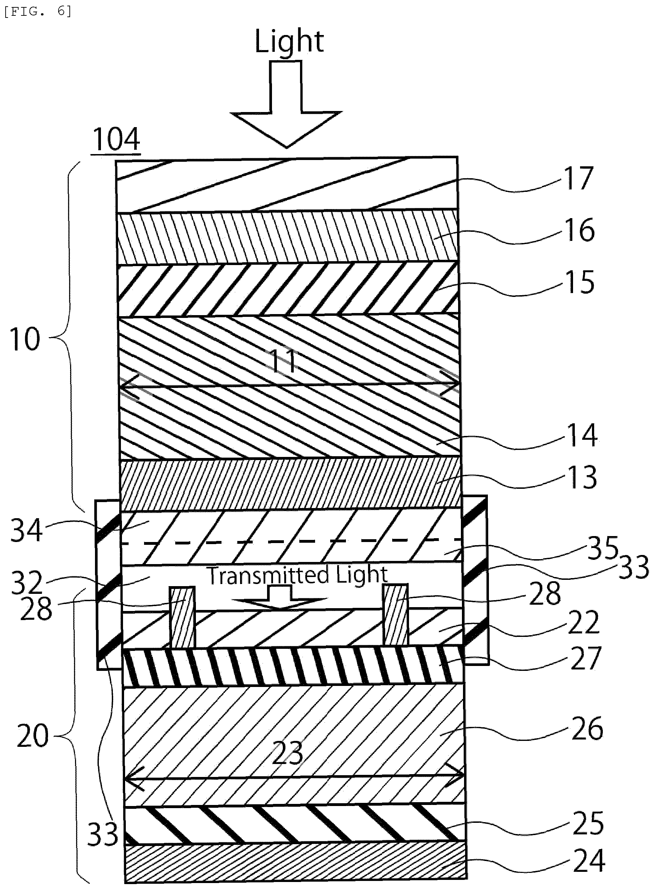

As a specific example of the solar cell 100, a schematic diagram of a specific solar cell 103 is shown in FIG. 6. The solar cell 103 shown in the schematic diagram of FIG. 6 has the anti-reflection layer 17, the first n-electrode 16, the n-type layer 15, the p-type light absorbing layer 14, the first p-electrode 13, and the substrate 12 from the light incident side, the refractive index-varying region 35 having the supporting layer 34, the gap layer 32, the second p-electrode 28, the anti-reflection film 22, the p-type layer 27, the n-type light absorbing layer 26, the BSF (Back Surface Field) layer 25, and the second n-electrode 24. The solar cell 103 shown in the schematic diagram of FIG. 6 uses the supporting layer 34 having a refractive index-varying region 35 instead of the refractive index-varying layer 31 shown in the schematic diagram of FIG. 5.

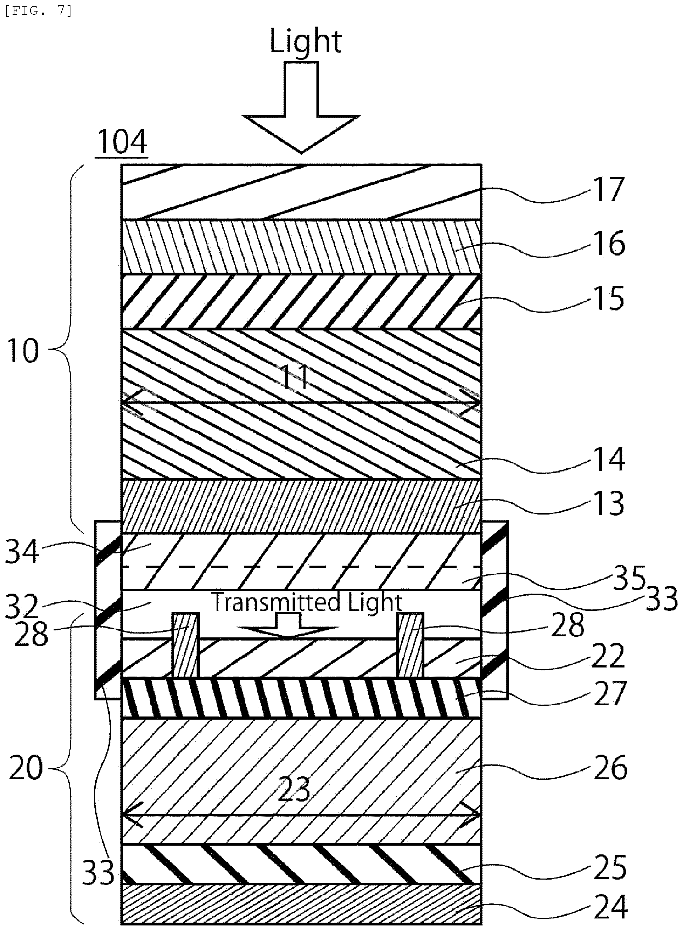

As a specific example of the solar cell 100, a schematic diagram of a specific solar cell 104 is shown in FIG. 7. The solar cell 104 shown in the schematic diagram of FIG. 7 has the anti-reflection layer 17, the first n-electrode 16, the n-type layer 15, the p-type light absorbing layer 14, the first p-electrode 13, the supporting layer 34 having a refractive index-varying region 35, the gap layer 32, the second p-electrode 28, the anti-reflection film 22, a p-type layer 27, an n-type light absorbing layer 26, the BSF (Back Surface Field) layer 25, and the second n-electrode 24 from the light incident side. The solar cell 104 shown in the schematic diagram of FIG. 7 does not use the substrate 12 of the solar cell 103 shown in the schematic diagram of FIG. 6, and the top cell 10 is provided on the surface opposite to the side of the refractive index-varying region 35 of the supporting layer 34. The form of using the supporting layer 34 as a substrate for the top cell 10 is the solar cell 104 in the schematic diagram of FIG. 7. For example, by fabricating the top cell 10 using the supporting layer 34 as a substrate, the solar cell 104 can be obtained without using the supporting layer 34.

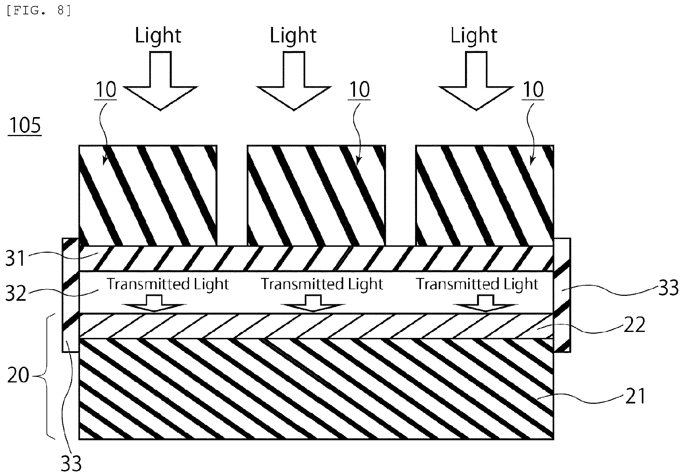

As a specific example of the solar cell 100, FIG. 8 shows a schematic diagram of a solar cell 105. The solar cell 105 shown in the schematic diagram of FIG. 8 has three of the top cells 10 and the one bottom cell 20. The plurality of the top cell 10 is electrically connected by wiring not shown in the drawings. The plurality of top cell 10 are provided on one or more refractive index-varying layers 31.

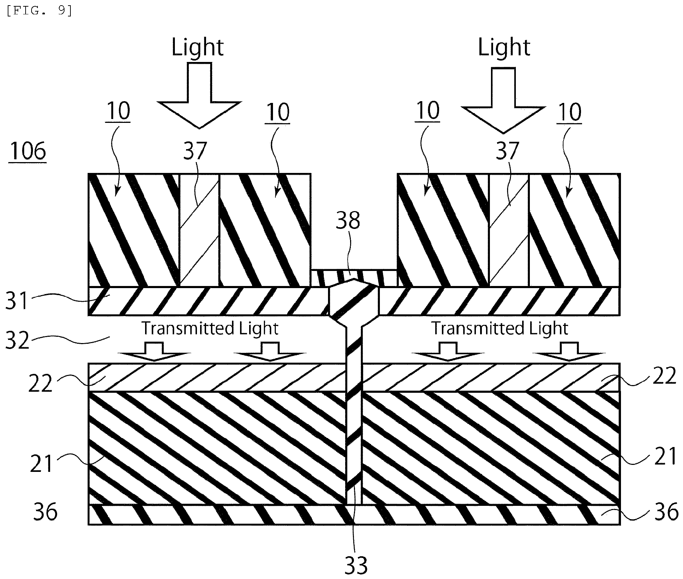

As a specific example of the solar cell 100, FIG. 9 shows a schematic diagram of a solar cell 106. The solar cell 106 shown in the schematic diagram of FIG. 9 has four of the top cells 10 and two of the bottom cells 20. The plurality of top cells 10 is electrically connected by wiring not shown in the drawings. The plurality of the top cells 10 is provided on one or more refractive index-varying layers 31. The plurality of bottom cells 20 is electrically connected by wiring not shown in the drawings. The plurality of bottom cells 20 can be held by a holding layer 36. The holding layer 36 may be a member that functions as wiring for electrically connecting the bottom cells 20.

An insulating member 37 having a refractive index substantially equal to that of the refractive index-varying layer 31 may be provided between adjacent top cells 10. The refractive index of the insulating member 37 present in the region between adjacent top cells 10 is preferably 0.8 times or more and 1.2 times or less that of the refractive index-varying layer 31, and more preferably 0.9 times or more and 1.1 times or less. The insulating member 37 may be, for example, a resin or oil.

Alternatively, an anti-reflection layer 38 similar to the anti-reflection layer 17 may be provided instead of the insulating member 37. Further, an anti-reflection layer 38 may be further provided on the light-incident surface side of the insulating member 37.

The holding member 33 of the solar cell 106 is preferably a member having light transmittance. It is preferable that the refractive index of the surface facing the gap layer 32 side of the holding member 33 is 1.0 or more and 1.1 or less, similar to the refractive index-varying layer 31 or the refractive index-varying region 35. By setting the refractive index of the surface of the region facing the gap layer 32 side of the holding member 33 to be 1.0 or more and 1.1 or less, the holding member 33 can also function as the refractive index-varying layer 31 (refractive index-varying region 35). Furthermore, when the holding member 33 covers the power generation effective region 23 of the bottom cell 20, the holding member 33 may have light diffusing properties to increase the amount of light introduced into the bottom cell 20 by scattering light. It is also possible to make the protrusion of the refractive index-varying layer 31 (supporting layer 34) the holding member 33.

By adopting the configuration of the first embodiment, light that has passed through the top cell 10 reaches the bottom cell 20 side with less reflection in various forms, contributing to an increase in the power generation amount on the bottom cell 20 side. In addition to providing an anti-reflection film on the light incident surface side of the solar cell, by providing it on the light emission surface side of the top cell 10, the overall conversion efficiency of the solar cell can be improved.

### (SECOND EMBODIMENT)

A second embodiment relates to a solar cell.

A solar cell of an embodiment comprises a top cell which is a transparent-type top cell, a bottom cell, a refractive index-varying layer or a supporting layer including a refractive index-varying region on the side of light-exiting surface and a gap layer between the refractive index-varying layer and the bottom cell or between the supporting layer and the bottom cell. The refractive index-varying layer on the side of the top cell has a higher refractive index. The refractive index-varying layer on the side of the bottom cell has a lower refractive index. The refractive index-varying region on the side of the top cell has a higher refractive index. The refractive index-varying region on the side of the bottom cell has a lower refractive index. The gap layer isolates electronically the top cell from the bottom cell.

A solar cell of an embodiment includes a top cell which is a transparent-type top cell. When the top cell is connected to a bottom cell, the solar cell includes a refractive index-varying layer or a supporting layer including a refractive index-varying region on the side of the bottom cell and a gap layer between the refractive index-varying layer and the bottom cell or between the supporting layer and the bottom cell. The refractive index-varying layer on the side of the top cell has a higher refractive index. The refractive index-varying layer on the side of the bottom cell has a lower refractive index. The refractive index-varying region on the side of the top cell has a higher refractive index. The refractive index-varying region on the side of the bottom cell has a lower refractive index. The gap layer can isolate electronically the top cell from the bottom cell.

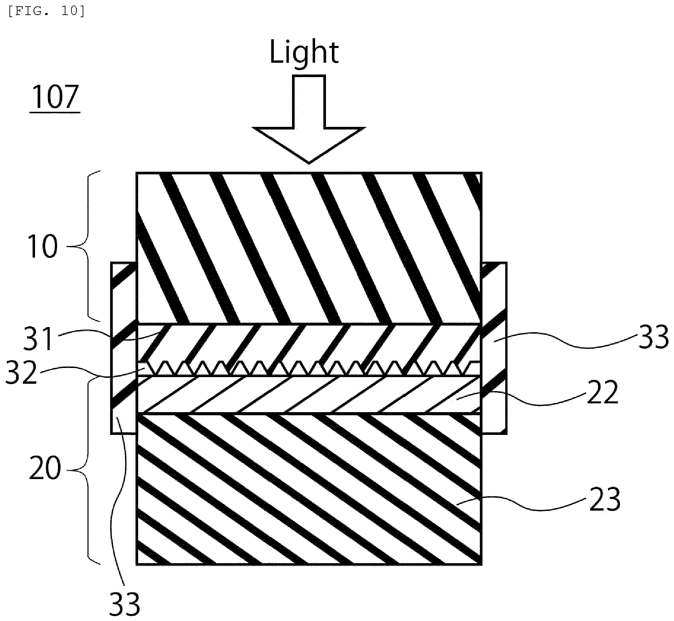

FIG. 10 shows a schematic diagram of a solar cell. The solar cell 107 shown in the schematic diagram of FIG. 10 comprises the top cell 10, the bottom cell 20, the refractive index-varying layer 31, the gap layer 32, and the holding member 33. The solar cell of the second embodiment also relates to a solar cell module. The solar cell 107 of the second embodiment is a variation of the first embodiment solar cell (100~106). Descriptions common to the first and second embodiments will be omitted.

The configuration of the solar cell where the top cell 10 is connected to the bottom cell 20 will be described.

The bottom cell 20 side of the refractive index-varying layer 31 (supporting layer 34) has unevenness (concave and convex structure). At least a portion of the tip of the convex part of the concave and convex structure on the bottom cell 20 side of the refractive index-varying layer 31 (refractive index-varying region 35) is in direct contact with the light incident surface side of the bottom cell 20.

When the convex part of the refractive index-varying layer 31 (refractive index-varying region 35) comes into contact with the bottom cell 20, the gap layer 32 is divided.

Even when the convex part of the refractive index-varying layer 31 (refractive index-varying region 35) is in direct contact with the bottom cell 20, since the surface of the refractive index-varying layer 31 (refractive index-varying region 35) has a low refractive index and the incident surface of the bottom cell 20 also has a low refractive index, reflection at the interface between the refractive index-varying layer 31 (refractive index-varying region 35) and the anti-reflection layer 22 is reduced. Similar to the first embodiment, this allows for an increase in the amount of light introduced into the bottom cell 20 side. By increasing the amount of light introduced to the bottom cell 20 side, it contributes to the improvement of power generation on the bottom cell 20 side. In addition to providing an anti-reflection film on the incident surface side of the solar cell, an anti-reflection film on the light emission surface side of the top cell 10 may improve the overall conversion efficiency of the solar cell.

### (THIRD EMBODIMENT)

A third embodiment relates to a solar cell.

A solar cell of an embodiment comprises a top cell which is a transparent-type top cell and a refractive index-varying layer or a supporting layer including a refractive index-varying region on the side of light-exiting surface. The refractive index-varying layer on the side of the top cell has a higher refractive index. The refractive index-varying layer on the opposite side of the top cell has a lower refractive index. The refractive index-varying region on the side of the top cell has a higher refractive index. The refractive index-varying region on the opposite side of top cell has a lower refractive index.

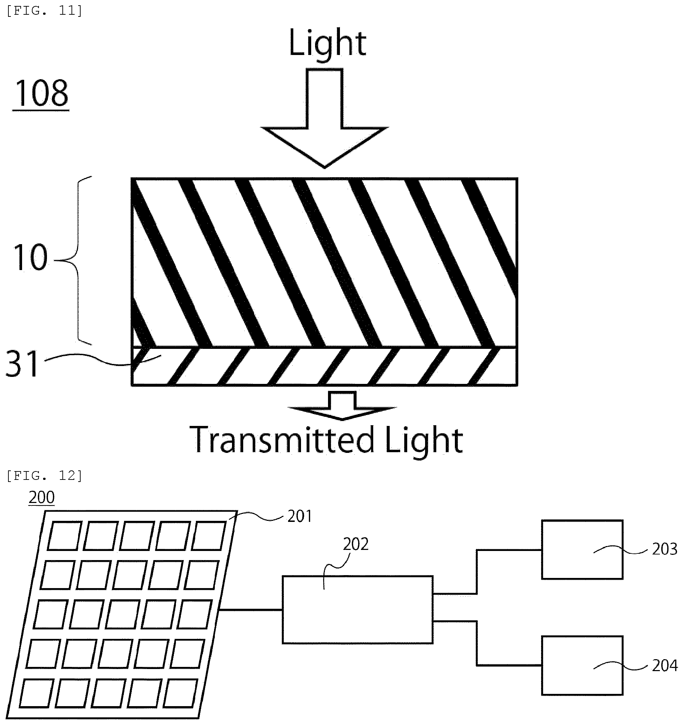

FIG. 11 shows a schematic diagram of a solar cell. The solar cell 108 of the third embodiment is a variation of the solar cell (100 to 106) of the first embodiment or the solar cell 107 of the second embodiment. The description of common content from the first embodiment to the third embodiment will be omitted.

As shown in the schematic diagram of FIG. 11, the solar cell 108 includes the top cell 10 and the refractive index-varying layer 31 (the supporting layer 34 including the refractive index-varying region 35). The light of the light incident on the top cell 10 that is not absorbed by the top cell 10 and is not reflected passes through the air outside the refractive index-varying layer 31 (the supporting layer 34 including the refractive index-varying region 35). By providing the refractive index-varying layer 31 (the supporting layer 34 including the refractive index-varying region 35) on the exiting surface side of the top cell 10, reflection at the boundary between air and the refractive index-varying layer 31 (the supporting layer 34 including the refractive index-varying region 35) on the exiting surface side can be reduced. Compared to the case where the refractive index-varying layer 31 (having a refractive index-varying region 35 included in a supporting layer 34) is not provided, the solar cell 108 has excellent light transmittance, so the amount of light transmits from the light exiting surface side of the top cell 10 can be increased. In addition, by changing the shape of the concave and convex portions or grooves on the surface opposite to the top cell 10 side of the refractive index-varying layer 31 (the supporting layer 34 including the refractive index-varying region 35), it is possible to make the solar cell 108 highly transparent, or to make it like frosted glass or privacy glass.

### (FOURTH EMBODIMENT)

A fourth embodiment relates to a solar power generation system. The solar cells of the first to third embodiments can be used as generators for power generation in the solar power generation system of the fourth embodiment. The solar power generation system of this embodiment generates electricity using a solar cell, and specifically includes a solar cell that generates electricity, means for converting the generated electricity into electrical power, and an energy storage means for storing the generated electricity or a load for consuming the generated electricity. FIG. 12 shows a configuration diagram of the solar power generation system 200 according to this embodiment. The solar power generation system in FIG. 12 includes a solar cell 201 (100-107), a converter 202, a secondary battery 203, and a load 204. The solar cell 201 is, for example, a solar module comprising a plurality of submodules where the top cell 10 of the solar cells 100-106 are electrically connected, and also comprises a plurality of the bottom cells 20, or a solar module comprising a plurality of submodules where the top cell 10 of the solar cell 107 is electrically connected. Either the secondary battery 203 or the load 204 may be omitted. The load 204 may also be configured to utilize electrical energy stored in the secondary battery 203. The converter 202 is a device including a circuit or element that performs power conversion such as voltage transformation and AC/DC conversion, such as a DC-DC converter, a DC-AC converter, or an AC-AC converter. The configuration of the converter 202 can be adopted appropriately depending on the generation voltage, the configuration of the secondary battery 203 and the load 204. Each of the top cell 10 and the bottom cell 20 can use the converter 202, respectively. A common converter 202 for the top cell 10 and the bottom cell 20 can be used in the solar power generation system.

Upon receiving light, the top cell 10 and the bottom cell 20 within solar cell 201 generate electricity, which then converted by the converter 202, either to be stored in the secondary battery 203 or consumed by the load 204. It is preferable to equip the solar cell 201 with devices such as a solar tracking drive system to constantly direct the solar cell towards the sun, concentrators to gather sunlight, or equipment for improving power generation efficiency.

The photovoltaic power generation system 200 is preferably used in properties such as residences, commercial facilities, and factories, or movable property such as vehicles, aircraft, and electronic equipment. By using solar cells with excellent conversion efficiency of embodiments in solar cell modules, an increase in the amount of electricity generated is expected.

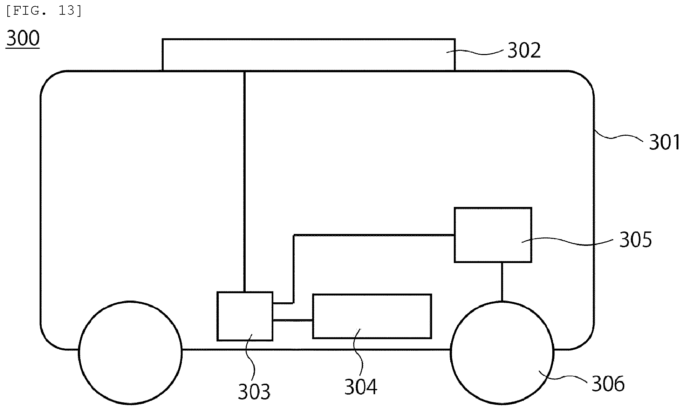

As an example of the use of the photovoltaic power generation system 200, a vehicle will be described. FIG. 13 shows a schematic diagram of a vehicle 300. The vehicle 300 shown in FIG. 13 comprises a vehicle body 301, a solar cell 302 (201), a power conversion device 303, a battery 304, a motor 305, and tires (wheels) 306. The electricity generated by the solar cell 302 mounted on the top of the vehicle body 301 is converted by the power conversion device 303 and charged to the battery 304 or consumed by the load such as the motor 305. The vehicle 300 can be moved by rotating the tires (wheels) 306 by the motor 305 using the power supplied from the solar cell 302 or the battery 304. When a light-transmitting solar cell 302 is adopted, it is also preferable to use the solar cell 302 as a window to generate electricity on the sides of the vehicle body 301 in addition to the top of the vehicle body 301.

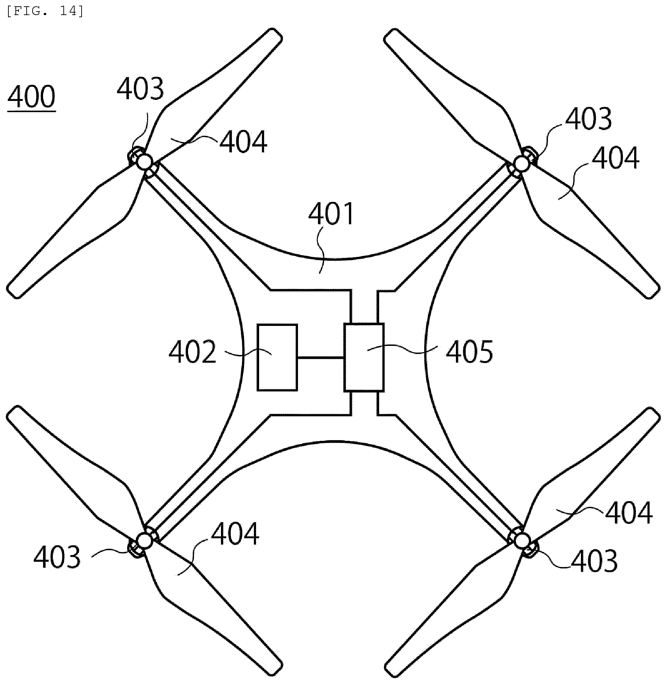

As an example of the use of the photovoltaic power generation system 200, a drone will be described. The drone uses a solar cell module 201. The configuration of this embodiment relating to the drone will be described with reference to the schematic diagram of the drone 400 shown in FIG. 14. The drone 400 comprises a solar cell module 401 (201), an airframe skeleton 402, a motor 403, a rotating wing 404, and a control unit 405. The solar cell module 401, the motor 403, the rotating wing 404, and the control unit 405 are arranged on the airframe skeleton 402. The control unit 405 converts or adjusts the output power from the solar cell module 401. The motor 403 uses the power output from the solar cell module 401 to rotate the rotating wing 404. By adopting the solar cell module 401 of this embodiment to the drone 400, a drone that can fly using more power is provided.

Hereinafter, the invention will be described more specifically based on the examples, but the invention is not limited to the following examples.

### (Example A)

### (Example A1)

On glass substrate 12, ITO (In:Sn = 80:20, film thickness 150 [nm]) and ATO (Sn:Sb = 98:2, film thickness 100 [nm]) are deposited on the upper surface as the first p-electrode 13 on the backside of the solar cell. A Cu₂O layer as the p-type light-absorbing layer 14 with a thickness of 6 [µm] is formed on the ATO film by sputtering in an oxygen and argon gas atmosphere. After forming the p-type light-absorbing layer 14, a Ga₂O₃ film with a thickness of 10 [nm] is deposited as the n-type layer 15. Then, AZO (ZnO:Al) with a thickness of 0.1 [µm] is deposited by ALD as the first n-electrode 16. The refractive index-varying layer 31 is formed on the opposite side of the substrate 12 from the first p-electrode 13 to obtain the top cell 10. In Example A1, the refractive index-varying layer 31 has pyramid-shaped concavo-convex with a diameter (diameter of the pyramid-shaped protrusion part) of 800 [nm] and with pitch of the protrusions is 800 [nm] on the surface of an acrylic resin layer with a refractive index of 1.49 as the base material. The height of the protrusions (≈ thickness of the refractive index-varying layer 31) is 1000 [nm]. The refractive index on the side opposite to the top cell 10 of the refractive index-varying layer 31 is 1.05.

A solar simulator that mimics an AM 1.5G light source is used, and the light intensity is adjusted to 1 sun using a reference Si cell under that light source. Measurements are conducted at atmospheric pressure with a room temperature of 25°C. The voltage is swept, and the short-circuit current density Jsc (current divided by cell area) is measured. When the horizontal axis represents voltage and the vertical axis represents current density, the point where the curve intersects the horizontal axis is the open-circuit voltage Voc. When the voltage and the current density are multiplied on a measurement curve and maximum points are Vmpp and Jmpp (maximum power point), respectively, FF = (Vmpp * Jmpp) / (Voc * Jsc), and a conversion efficiency Eff. is obtained by Eff. = Voc * Jsc * FF.

### (Examples A2-A14, Comparative Examples A1-A2)

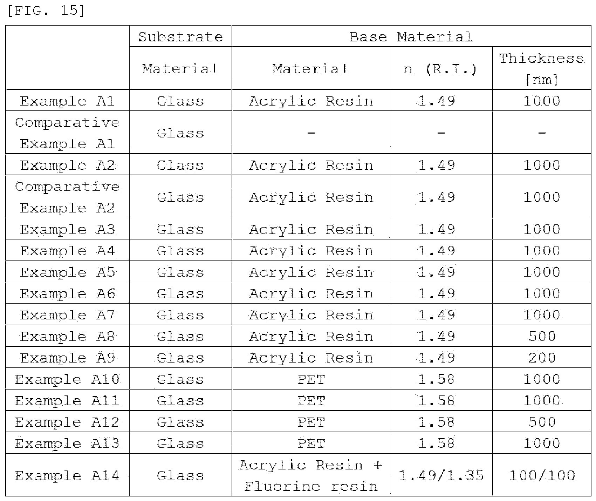

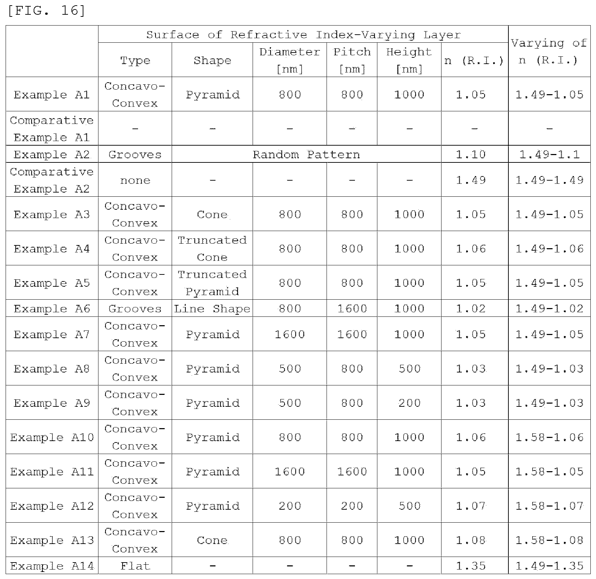

Top cells are obtained as in Example A1 except for the formation of the refractive index-varying layer 31, as shown in Tables of FIG. 15 and FIG. 16 ("n(R.I.)" represents "Refractive Index", "PET" represents "polyethylene terephthalate"). Evaluation was conducted similarly to Example A1. Note that Comparative Example A1 does not include the refractive index-varying layer 31. When the refractive index-varying layer 31 is multilayered, materials on the top cell 10 side are listed on the left in the "base material" column of Table of FIG. 15, and materials on the opposite side of the top cell 10 are listed on the right in the "base material" column of Table of FIG. 15.

Transmittance is rated A when the luminous flux (cd) of light in the wavelength band of 700 [nm] or more and 1000 [nm] or less is more than 102% and 130% or less of the luminous flux (cd) in the same wavelength band for the control example. Transmittance is rated B when the luminous flux (cd) of light in the wavelength band of 700 [nm] or more and 1000 [nm] or less is 98% or more and 102% or less of the luminous flux (cd) in the same wavelength band for the control example. Transmittance is rated C when the luminous flux (cd) of light in the wavelength band of 700 [nm] or more and 1000 [nm] or less is less than 98% of the luminous flux (cd) in the same wavelength band for the control example. The transmittance evaluation criteria are the same for Examples A and all other examples.

When Jsc of the example is 0.95 times or more and 1.05 times or less of the Jsc of the control example, the evaluation rating is A. When Jsc of the example is less than 0.95 times of the Jsc of the control example the evaluation rating is B. The Jsc evaluation criteria are the same for Examples A and all other examples.

When Voc of the example is 0.95 times or more and 1.05 times or less of the Voc of the control example, the evaluation rating is A. When Voc of the example is less than 0.95 times of the Voc of the control example the evaluation rating is B. The Voc evaluation criteria are the same for Examples A and all other examples.

When FF of the example is 0.95 times or more and 1.05 times or less of the FF of the control example, the evaluation rating is A. When FF is less than 0.95 times of the FF of the control example the evaluation rating is B. The FF evaluation criteria are the same for Examples A and all other examples.

When conversion efficiency (Eff.) of the example is more than 1.05 times of the conversion efficiency of the control example, the evaluation rating is A. When conversion efficiency of the example is 0.95 times or more and 1.05 times or less of the conversion efficiency of the control example, the evaluation rating is B. When conversion efficiency of the example is less than 0.95 times of the conversion efficiency of the control example the evaluation rating is C. The conversion efficiency evaluation criteria are the same for Examples A and all other examples.

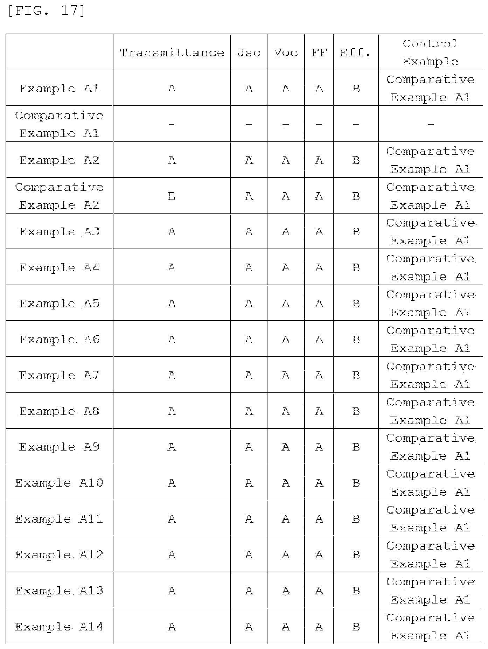

The evaluation results of Example A are shown in Tables of FIG. 17.

In various samples with different shapes and composed of multiple materials, transmittance is improved in all cases. While the amount of light transmitted to the bottom cell side increased, there is almost no change in the absorption amount of the top cell. As a result, no significant differences are observed in Jsc, Voc, FF, or conversion efficiency. These results indicate that introducing the refractive index-changing layer on the bottom cell side does not adversely affect the top cell. In Example A, the solar cell is obtained using a compound semiconductor as the p-type light-absorbing layer 14. However, similar improvements in the transmittance of the top cell 10 can be expected for other types of solar cells using perovskite compounds or other materials.

### (Example B)

### (Example B1)

An RERC-type polycrystalline Si solar cell is used as the bottom cell 20, and combined with the top cell 10 equipped with the refractive index-varying layer 31 from Example A1 to configure a multi-junction solar cell. The gap layer 32 (air gap is provided between the refractive index-varying layer 31 and the bottom cell 20, such that the distance from the tip of the refractive index-varying layer 31 to the second p-electrode 28 of the bottom cell 20 is 100 [µm]. The same light source as in Example A is irradiated, and the total conversion efficiency of the top cell 10 and the bottom cell 20 was measured. The difference in conversion efficiency compared to the multi-junction solar cell of the control example is then evaluated.

### (Example B2 - Example B14, Comparative Example B1 - Comparative Example B2)

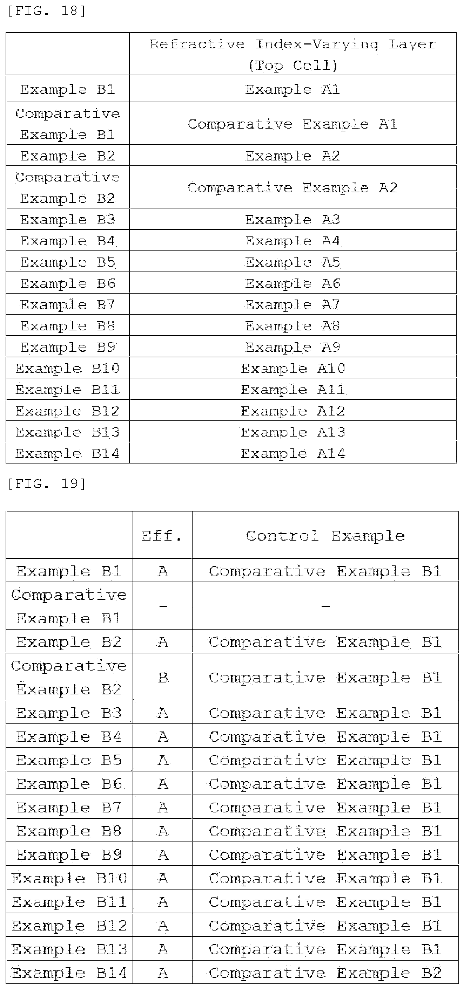

The top cell 10 is changed and the total conversion efficiency of the top cell 10 and the bottom cell 20 is measured similarly to Example B1, and the difference in conversion efficiency compared to the multi-junction solar cell of the control example is evaluated. The configurations of the top cells 10 used in Example B are shown in Table of FIG.18.

The evaluation results of Example B are shown in Tables of FIG. 19.

As described above, there is no significant difference in conversion efficiency on the top cell side. However, compared to Comparative Example A1, an improvement in light transmittance can be observed. This leads to improved Jsc of the bottom Si cell and consequently, an improvement in conversion efficiency. As Comparative Example B2, acrylic resin is introduced, and a slight improvement due to supposed to be an effect such as anti-reflection. The conversion efficiency can be recognized. However, this improvement is not as significant as observed in other examples. These results confirm that introducing a layer with a varying refractive index improves the conversion efficiency of the bottom cell. In Example B14, although it is a flat layer, adding two layers resulted in an anti-reflection effect, leading to further improvement in conversion efficiency compared to Comparative Example B2. This result proves the effectiveness of gradually lowering the refractive index from the glass substrate side. Comparative Example B2 uses the top cell 10 with acrylic resin (no refractive index variation) replacing the refractive index-varying layer 31 from Comparative Example A2, resulting in no observable improvement in conversion efficiency compared to Comparative Example B1.

### (Example C)

### (Example C1)

On glass substrate 12, ITO (In:Sn = 80:20, film thickness 150 [nm]) and ATO (Sn:Sb = 98:2, film thickness 100 [nm]) are deposited on the upper surface as the first p-electrode 13 on the backside of the solar cell. A Cu₂O layer as the p-type light-absorbing layer 14 with a thickness of 6 [µm] is formed on the ATO film by sputtering in an oxygen and argon gas atmosphere. After forming the p-type light-absorbing layer 14, a Ga₂O₃ film with a thickness of 10 nm is deposited as the n-type layer 15. Then, AZO (ZnO:Al) with a thickness of 0.1 µm is deposited by ALD as the first n-electrode 16. The refractive index-varying layer 31 is formed on the opposite side of the substrate 12 from the first p-electrode 13 to obtain the top cell 10. In Example C1, the supporting layer 34 is an acrylic resin layer with a refractive index of 1.49 and a thickness of 50 [um]. In Example C1, the surface of the refractive index-varying layer 31 has pyramid-shaped concavo-convex with a diameter (diameter of the pyramid-shaped protrusion part) of 800 [nm], with pitch of 800 [nm], and with height of 1000 [nm]. The refractive index on the side opposite to the top cell 10 of the refractive index-varying region 35 is 1.05.

### (Examples C2-C16 and Comparative Examples C1-C2)

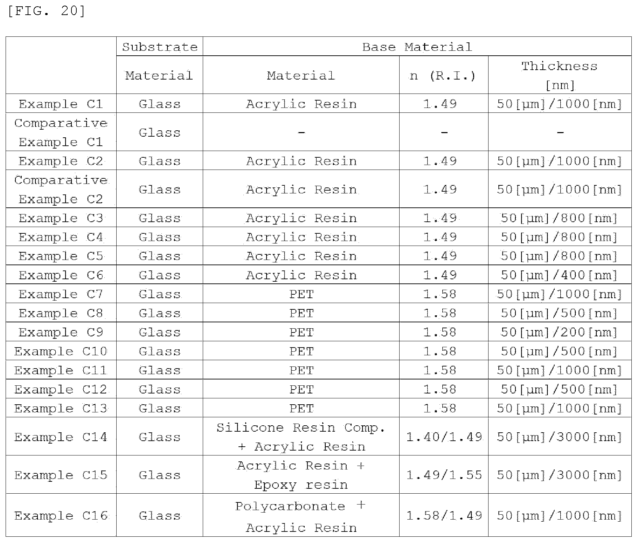

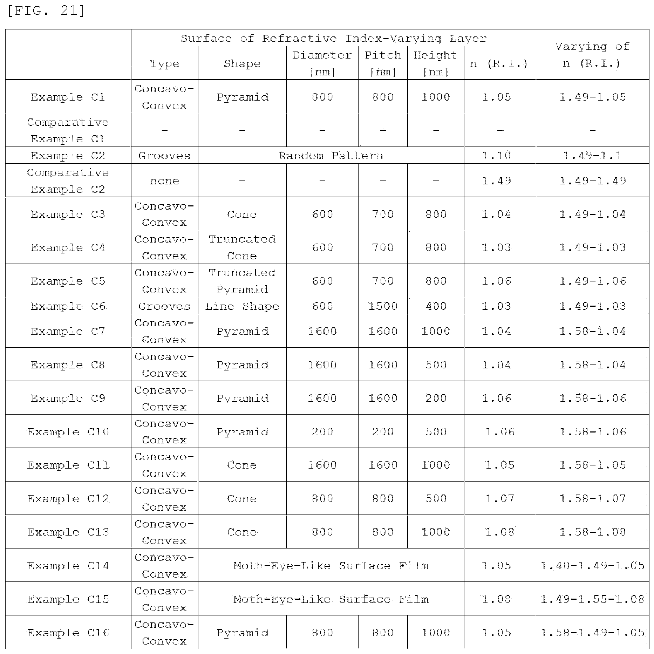

As shown in Tables of FIG. 20 and FIG. 21 (where "Silicone Resin Comp." represents "Silicone Resin Composition"), top cells are obtained similarly to Example C1, except for the formation of the supporting layer 34. The evaluation is performed as in Example A1. Comparative Example C1 did not have the supporting layer 34. When the supporting layer 34 consisted of multiple layers, the materials on the side of the top cell 10 are listed on the left side in the column for the supporting layer 34 in Table 20, and the materials on the opposite side of the top cell 10 are listed on the right side.

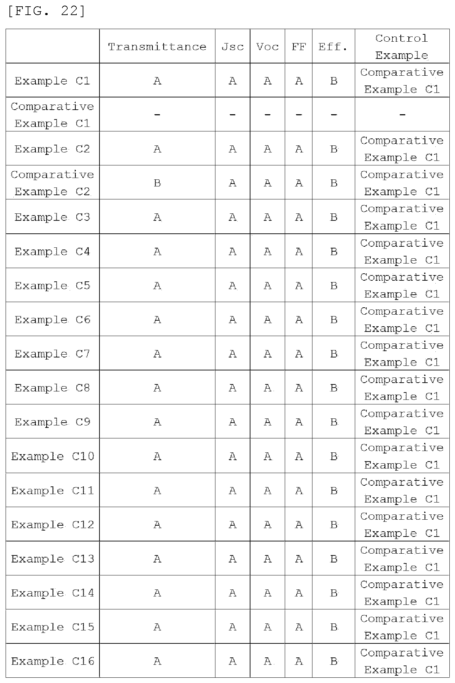

The evaluation results of Example C are shown in Tables of FIG. 22.

In various samples with different shapes and composed of multiple materials, transmittance is improved in all cases. While the amount of light transmitted to the bottom cell side increased, no significant differences are observed in Jsc, Voc, FF, or conversion efficiency, since there is almost no change in the absorption amount of the top cell. These results indicate that introducing the refractive index-changing layer on the bottom cell side does not adversely affect the top cell. In Examples C14 and C15, the effect of films with moth-eye surface structures is examined. Like other examples, transmittance improvement is observed. In Example C16, the effect of laminated resin is examined. While transmittance is superior to Comparative Examples C1 and C2, the improvement effect is smaller than in other examples due to a larger refractive index difference between the laminated resin and the gap layer 32. In Comparative Example C2, an acrylic resin with a constant refractive index is used. Therefore, it is considered that the transmittance is lower compared to Comparative Example C1 due to the light absorption of the acrylic resin itself. In Example C, a compound semiconductor was used as the p-type light-absorbing layer 14 for the solar cell. However, similar improvements in the transmittance of the top cell 10 can be expected for other types of solar cells using perovskite compounds or other materials.

### (Example D)

An RERC-type polycrystalline Si solar cell is used as the bottom cell 20 and combined with the top cell 10 from Example C1, which includes the supporting layer 34, to configure a multi-junction solar cell. The refractive index-varying region 35 side of the supporting layer 34 directly contacts the bottom cell 20. The gap layer 32 is provided in the gap between the concave portions of the refractive index-varying region 35 and the surface of the anti-reflection layer 22 of the bottom cell 20. Air exists in the gap layer 32. The same light source as in Example A is irradiated, and the total conversion efficiency of the top cell 10 and the bottom cell 20 is measured. The difference in conversion efficiency compared to the control example multi-junction solar cell is then evaluated.

### (Example D2 - Example D16, Comparative Example D1 - Comparative Example D2)

The top cell 10 is changed, and the total conversion efficiency of the top cell 10 and the bottom cell 20 is measured similarly to Example D1. The difference in conversion efficiency compared to the control example multi-junction solar cell is evaluated.

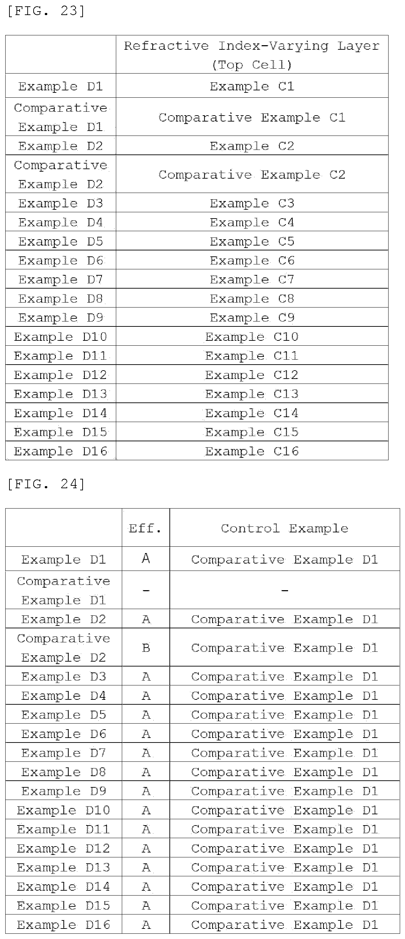

The evaluation results of Example D are shown in Tables of FIG. 24.

Similar to Example B, an improvement in transmittance can be observed compared to the state of Comparative Example C1, which contributes an improvement in Jsc of the bottom cell and conversion efficiency. In Comparative Example D2, where acrylic resin with a constant refractive index is used instead of the supporting layer 34, almost no influence on the improvement of conversion efficiency is observed compared to Comparative Example D1. These results demonstrate that even when these substrate layers are present, the conversion efficiency of the bottom cell can be improved by having a region where the refractive index changes on the surface. Similarly, improvements in efficiency are also observed in Examples D14, D15, and D16, where the resin layer is thick with two layers. It is considered that this effect is due to the large difference in refractive index between the glass substrate used as the top cell and the resin layer.

### (Example E)

### (Example E1)

On the surface of the supporting layer 34 made of glass with a refractive index of 1.52 and having the refractive index-varying region 35 on the backside, ITO (In:Sn = 80:20, film thickness 150 [nm]) and ATO (Sn:Sb = 98:2, film thickness 100 [nm]) are deposited on the side contacting the glass as the first p-electrode 13. On the ATO, a Cu₂O layer with a thickness of 6 [µm] is formed as the p-type light-absorbing layer 14 by sputtering in an oxygen and argon gas atmosphere. After forming the p-type light-absorbing layer 14, a Ga₂O₃ film with a thickness of 10 [nm] is formed as the n-type layer 15. Then, AZO (ZnO:Al) with a thickness of 0.1 [µm] is deposited by ALD as the first n-electrode 16 to obtain the top cell 10. In Example E1, the supporting layer is used instead of the glass substrate. The refractive index-varying region 35 has concavo-convex on the side opposite the top cell 10. The concavo-convex of Example E1 has pyramid-shaped concavo-convex with a diameter (diameter of the pyramid-shaped protrusion part) of 500 [nm], with pitch of the protrusions is 500 [nm], and with height of 1000 [nm]. The refractive index on the side opposite the top cell 10 of the refractive index-varying region 35 is 1.06.

### (Examples E2-E16 and Comparative Examples E1-E2)

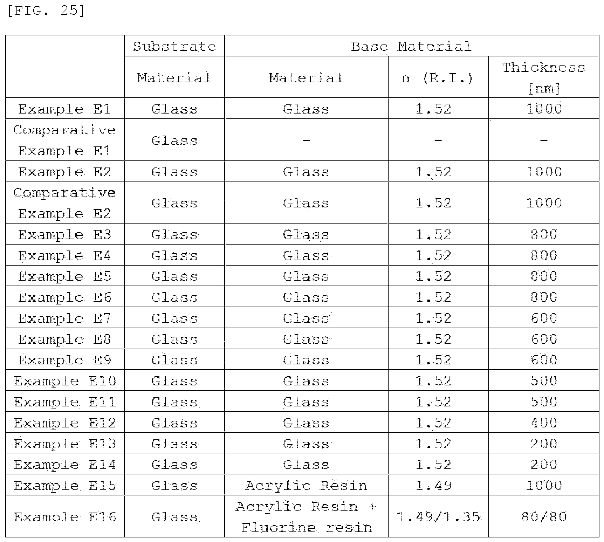

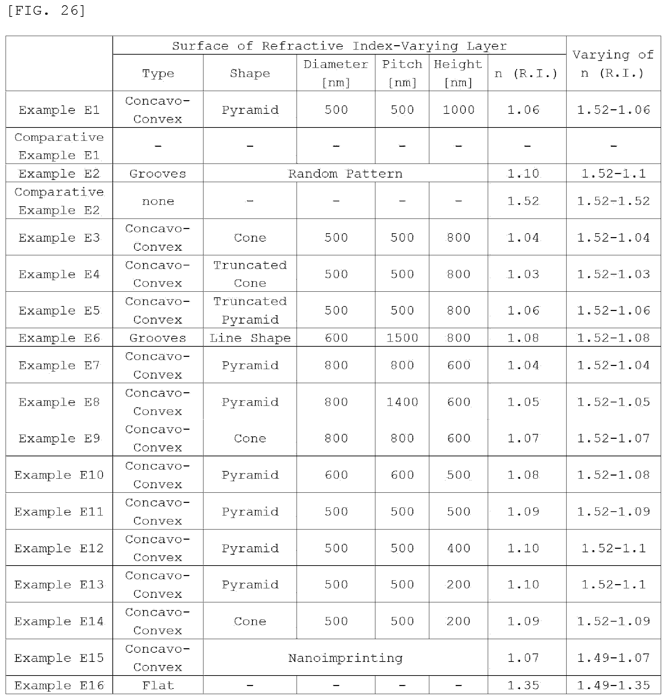

As shown in the Tables of FIG. 25 and FIG. 26, top cells are obtained similarly to Example E1 except for the formation of the supporting layer 34, and evaluation is conducted as in Example A1. Comparative Example E1 does not have the supporting layer 34. When the supporting layer 34 consists of multiple layers, in FIG. 25, materials on the side of the top cell 10 are listed on the left side within the column for the supporting layer 34, and materials on the opposite side of the top cell 10 are listed on the right side.

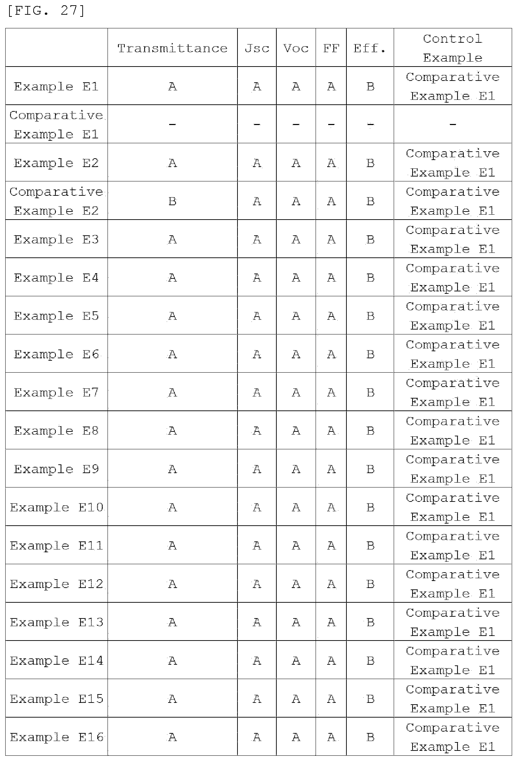

The evaluation results of Example E are shown in Tables of FIG. 27.

Regarding to the Example E, improvements in transmittance are observed across various samples using multiple materials and shapes. The amount transmitted to the bottom cell side has increased, but there is almost no change in the absorption amount of the top cell, so no significant difference is observed in Jsc, Voc, FF, or conversion efficiency. From these findings, it can be understood that introducing the refractive index-changing layer on the bottom cell side of the top cell does not have any adverse effects on the top cell itself. Examples E15 and E16 are examples that evaluate the effect of refractive index change due to nanoimprinting and multilayer structures. As with other examples, improvements in transmittance are observed. In Example E, a compound semiconductor was used as the p-type light-absorbing layer 14 to create a solar cell, but similarly, the transmittance of the top cell 10 is expected to improve in other solar cells using perovskite compounds or the like.

### (Example F)

### (Example F1)

A PERC-type polycrystalline Si solar cell is used as the bottom cell 20 and combined with the top cell 10 from Example E1, which includes the refractive index-varying layer 31, to configure a multi-junction solar cell. Air gap as the gap layer 32 is provided between the refractive index-varying layer 31 and the bottom cell 20, such that the distance between the tip of the refractive index-varying layer 31 and the second p-electrode 28 of the bottom cell 20 is 100 [µm]. The same light source as in Example A is irradiated, and the total conversion efficiency of the top cell 10 and the bottom cell 20 is measured. The difference in conversion efficiency compared to a control example is then evaluated.

### (Example F2 - Example F16, Comparative Example F1 - Comparative Example F2)

The top cell 10 is changed, and the total conversion efficiency of the top cell 10 and the bottom cell 20 is measured similarly to Example F1. The difference in conversion efficiency compared to the control example multi-junction solar cell is evaluated.

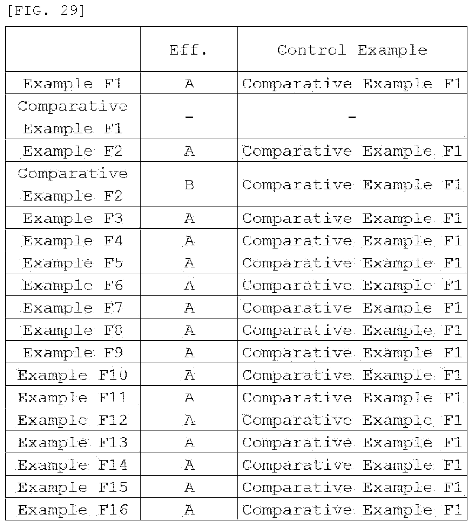

The evaluation results of Example F are shown in Tables of FIG. 29.

Similar to Examples B and D, an improvement in transmittance is observed compared to the state of Comparative Example F1. This contributes to an improvement in Jsc (short-circuit current density) of the bottom cell and conversion efficiency. In Comparative Example F2, where acrylic resin with a constant refractive index is used instead of the supporting layer 34, almost no influence on the improvement of conversion efficiency is observed compared to Comparative Example F1. These results demonstrate that even when unevenness is directly formed onto the glass substrate, the conversion efficiency of the bottom cell can be improved by having a region where the refractive index changes on its surface. Similarly, improvements in efficiency are also observed in Examples F15 and F16, which use nanoimprinting and multi-layer structures for refractive index change, respectively.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

In the specification, some elements are represented only by chemical symbols for elements.

## Claims

1. A solar cell (100) comprising:
a top cell (10) which is a transparent-type top cell, wherein
when the top cell (10) is connected to a bottom cell (20), the top cell (10) comprises a refractive index-varying layer (31) or a supporting layer (34) comprising a refractive index-varying region (35) on the side of the bottom cell (20) and a gap layer (32) between the refractive index-varying layer (31) and the bottom cell (20) or between the supporting layer (34) and the bottom cell,
the refractive index-varying layer (31) on the side of the top cell (10) has a higher refractive index,
the refractive index-varying layer (31) on the side of the bottom cell (20) has a lower refractive index,
the refractive index-varying region (35) on the side of the top cell (10) has a higher refractive index,
the refractive index-varying region (35) on the side of the bottom cell (20) has a lower refractive index, and
the gap layer (32) can isolate electronically the top cell (10) from the bottom cell (20).

2. A solar cell (100) comprising: a top cell (10) which is a transparent-type top cell, wherein
when the top cell (10) is connected to a bottom cell (20), the top cell (10) comprises a refractive index-varying layer (31) or a supporting layer (34) comprising a refractive index-varying region (35) on the side of the bottom cell(20) and a gap layer (32) between the refractive index-varying layer (31) and the bottom cell(20) or between the supporting layer (34) and the bottom cell(20),
the refractive index-varying layer (31) on the side of the top cell (10) has a higher refractive index,
the refractive index-varying layer (31) on the side of the bottom cell (20) has a lower refractive index,
the refractive index-varying region (35) on the side of the top cell (10) has a higher refractive index,
the refractive index-varying region (35) on the side of the bottom cell (20) has a lower refractive index,
the refractive index-varying layer (31) is not in direct contact with the bottom cell (20), and
the supporting layer (34) is not in direct contact with the bottom cell (20).

3. A solar cell (100) comprising:
a top cell (10) which is a transparent-type top cell; and
a refractive index-varying layer (31) or a supporting layer comprising a refractive index-varying region on the side of a light-exiting surface, wherein
the refractive index-varying layer (31) on the side of the top cell (10) has a higher refractive index,
the refractive index-varying layer (31) on the opposite side of the top cell (10) has a lower refractive index,
the refractive index-varying region (34) on the side of the top cell (10) has a higher refractive index, and
the refractive index-varying region (34) on the opposite side of top cell (10) has a lower refractive index.

4. The solar cell (100) according to any one of claims 1 to 3, wherein
the refractive index-varying layer (31) is electrically insulative, and
the supporting layer (34) is electrically insulative.

5. The solar cell (100) according to claim 1 or 2, wherein
the gap layer (32) is electrically insulative.

6. The solar cell (100) according to any one of claims 1 to 4, wherein
the refractive index-varying layer (31) is in direct contact with the top cell (10),
the refractive index-varying layer (31) is placed on a light-exiting surface of the top cell (10),
the supporting layer (34) is in direct contact with the top cell (10), and
the supporting layer (34) is placed on a light-exiting surface of the top cell (10).

7. The solar cell (100) according to any one of claims 1 to 4 and 6, wherein
the refractive index of the surface of the refractive index-varying layer (31) on the opposite side of the top cell (10) is 1.0 or more and 1.1 or less, and
refractive index of the surface of the refractive index-varying region (35) on the opposite side of the top cell (10) is 1.0 or more and 1.1 or less.

8. The solar cell (100) according to any one of claims 1 to 3, 6, and 7, wherein
the refractive index of the top cell (10) on the side of the refractive index-varying layer (31) is 1.3 or more and 2.2 or less, and
the refractive index of the top cell (10) on the side of the supporting layer (34) is 1.3 or more and 2.2 or less.

9. The solar cell (100) according to any one of claims 1 to 3 and 6 to 8, wherein
refractive index of a member of the top cell (10) which is in direct contact with the refractive index-varying layer (31) is 1.3 or more and 2.2 or less, and
refractive index of a member of the top cell (10) which is in direct contact with the supporting layer (34) is 1.3 or more and 2.2 or less.

10. The solar cell (100) according to any one of claims 1 to 3 and 6 to 9, wherein
an absolute value of difference between refractive index of a member of the top cell (10) which is in direct contact with the refractive index-varying layer (31) and refractive index of the refractive index-varying layer (31) on the side of the top cell (10) is 0.0 or more and 1.0 or less, and
an absolute value of difference between refractive index of a member of the top cell (10) which is in direct contact with the supporting layer (34) and refractive index of a region excluding the refractive index-varying region (34) on the side of the top cell (10) is 0.0 or more and 1.0 or less.

11. The solar cell (100) according to claim 1, 2, or 5 wherein
the gap layer (32) is a layer including air, a layer including inert gas or a layer of vacuumed region.

12. The solar cell (100) according to claim 1, 2, or 5, wherein
the top cell (10) has a light-absorbing layer whose bandgap is wider than that of the bottom cell.

13. The solar cell (100) according to claim 1, 2, 5, or 12, further comprising a holding member (33), wherein
the holding member (33) secures the top cell (10) with the bottom cell (20).

14. The solar cell (100) according to any one of claims 1 to 10,
the refractive index of the refractive index-varying layer (31) decreases gradually or/and step-likely towards the opposite side of the top cell (10) from the side of the top cell (10), and
the refractive index of the refractive index-varying region (35) decreases gradually or/and step-likely towards the opposite side of the top cell (10) from the side of the top cell (10).

15. The solar cell (100) according to any one of claims 1 to 14, further comprising a bottom cell (20).

16. A photovoltaic power generation system (200) comprising:
the solar cell (100) according to any one of claim 1 to 15 which generates electric power.
